(19) 

Europäisches
Patentamt
European
Patent Office
Office européen
des brevets

(11) **EP 4 694 175 A1**

(12) **EUROPEAN PATENT APPLICATION**
published in accordance with Art. 153(4) EPC

(43) Date of publication:
**11.02.2026 Bulletin 2026/07**

(21) Application number: **24780190.5**

(22) Date of filing: **25.03.2024**

(51) International Patent Classification (IPC):
**H04N 25/78** (2023.01)     **H03K 5/08** (2006.01)

(52) Cooperative Patent Classification (CPC):
**H03K 5/08; H04N 25/78**

(86) International application number:
**PCT/JP2024/011718**

(87) International publication number:
**WO 2024/204072 (03.10.2024 Gazette 2024/40)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **24.03.2023 JP 2023048728**

(71) Applicant: **Sony Semiconductor Solutions
Corporation
Atsugi-shi, Kanagawa 243-0014 (JP)**

(72) Inventors:
• **INOUE Fumihiro
  Atsugi-shi, Kanagawa 243-0014 (JP)**
• **KUDO Ryota
  Atsugi-shi, Kanagawa 243-0014 (JP)**

(74) Representative: **MFG Patentanwälte
Meyer-Wildhagen Meggle-Freund
Gerhard PartG mbB
Amalienstraße 62
80799 München (DE)**

(54) **IMAGING DEVICE**

(57)     Provided is an imaging device capable of reducing a size of a band limiting capacitor while reducing noise generated at the time of inversion of a comparator circuit.

An imaging device of the present disclosure is an imaging device including an A/D converter including a comparator circuit, in which the comparator circuit includes a first amplifier circuit, a second amplifier circuit provided at a subsequent stage of the first amplifier circuit, a band limiting capacitor provided between an output unit of the first amplifier circuit and an input unit of the second amplifier circuit, and a resistance element with one end directly or indirectly connected to power supply potential or reference potential, and one end of the band limiting capacitor is connected to a first node formed between the output unit of the first amplifier circuit and the input unit of the second amplifier circuit, and another end of the band limiting capacitor is connected to a second node formed in a middle or a terminal of the resistance element.

FIG. 5B

**Description**

TECHNICAL FIELD

The present disclosure relates to an imaging device.

BACKGROUND ART

In order to improve low noise performance of an analog to digital (A/D) converter used in an imaging device, it is important to reduce noise generated in a comparator circuit included in the A/D converter. Patent Document 1 discloses a configuration of reducing noise at the time of inversion of a comparator circuit by providing a capacitor for band limiting ("band limiting capacitor") between a first stage differential amplifier circuit and a second stage amplifier circuit configuring a comparator circuit.

In Patent Document 1, in order to enhance the noise reduction effect generated at the time of inversion of the comparator circuit, it is necessary to increase capacitance, that is, a size of the band limiting capacitor. In contrast, in order to increase a slew rate between a first stage differential amplifier circuit and a second stage amplifier circuit, it is necessary to increase capacitance, that is, a size of the band limiting capacitor.

CITATION LIST

PATENT DOCUMENT

Patent Document 1: Japanese Patent Application Laid-Open No. 2020-188477

SUMMARY OF THE INVENTION

PROBLEMS TO BE SOLVED BY THE INVENTION

The present disclosure is for solving the problem described above, and an object thereof is to provide an imaging device capable of reducing a size of a band limiting capacitor while reducing noise generated at the time of inversion of a comparator circuit.

SOLUTIONS TO PROBLEMS

In order to solve the above-described problem, an imaging device according to the present disclosure is an imaging device including an A/D converter including a comparator circuit, in which the comparator circuit includes a first amplifier circuit, a second amplifier circuit provided at a subsequent stage of the first amplifier circuit, a band limiting capacitor provided between an output unit of the first amplifier circuit and an input unit of the second amplifier circuit, and a resistance element with one end directly or indirectly connected to power supply potential or reference potential, and one end of the band limiting capacitor is connected to a first node formed between the output unit of the first amplifier circuit and the input unit of the second amplifier circuit, and another end of the band limiting capacitor is connected to a second node formed in a middle or a terminal of the resistance element.

BRIEF DESCRIPTION OF DRAWINGS

Fig. 1 is a diagram illustrating a configuration of an imaging device according to a first embodiment.
Fig. 2 is a diagram illustrating a detailed configuration of a comparator circuit according to the first embodiment.
Fig. 3 is a time chart for describing an operation of the comparator circuit according to the first embodiment at the time of inversion.
Fig. 4A is a diagram for describing a slew rate of a comparator circuit according to the conventional technology.
Fig. 4B is a diagram for describing a slew rate of a comparator circuit according to the conventional technology.
Fig. 5A is a diagram for describing a slew rate of the comparator circuit according to the first embodiment.
Fig. 5B is a diagram for describing a slew rate of the comparator circuit according to the first embodiment.
Fig. 6 is a diagram illustrating a substantial configuration of a comparator circuit according to a second embodiment.
Fig. 7 is a diagram illustrating a substantial configuration of a comparator circuit according to a third embodiment.
Fig. 8 is a diagram illustrating a substantial configuration of a comparator circuit according to a fourth embodiment.

Fig. 9 is a diagram illustrating capacitance of a band limiting capacitor C necessary for obtaining the same slew rate as that of the conventional technology in the comparator circuit according to the fourth embodiment.

Fig. 10 is a diagram illustrating a substantial configuration of a comparator circuit according to a fifth embodiment.

Fig. 11 is a time chart for describing an operation of the comparator circuit according to the fifth embodiment at the time of inversion.

Fig. 12A is a diagram for describing a slew rate of the comparator circuit according to the fifth embodiment.

Fig. 12B is a diagram for describing a slew rate of the comparator circuit according to the fifth embodiment.

Fig. 12C is a diagram for describing a slew rate of the comparator circuit according to the fifth embodiment.

Fig. 13 is a diagram illustrating a substantial configuration of a comparator circuit according to a sixth embodiment.

Fig. 14 is a diagram illustrating a substantial configuration of a comparator circuit according to a seventh embodiment.

Fig. 15 is a diagram illustrating a substantial configuration of a comparator circuit according to an eighth embodiment.

Fig. 16 is a diagram illustrating a relationship of a current of the comparator circuit according to the eighth embodiment.

Fig. 17 is a diagram illustrating a substantial configuration of a comparator circuit according to a ninth embodiment.

Fig. 18 is a time chart for describing an operation of the comparator circuit according to the ninth embodiment at the time of inversion.

Fig. 19 is a diagram illustrating a substantial configuration of a comparator circuit according to a modification of the ninth embodiment.

Fig. 20 is a diagram illustrating a substantial configuration of a comparator circuit according to a tenth embodiment.

Fig. 21 is a diagram illustrating a substantial configuration of a comparator circuit according to a first modification of the tenth embodiment.

Fig. 22 is a diagram illustrating a substantial configuration of a comparator circuit according to a second modification of the tenth embodiment.

Fig. 23 is a diagram illustrating a substantial configuration of a comparator circuit according to an eleventh embodiment.

Fig. 24 is a diagram illustrating a substantial configuration of a comparator circuit according to a twelfth embodiment.

Fig. 25 is a diagram illustrating a substantial configuration of a comparator circuit according to a thirteenth embodiment.

Fig. 26 is a diagram illustrating a substantial configuration of a comparator circuit according to a fourteenth embodiment.

Fig. 27 is a diagram illustrating a substantial configuration of a comparator circuit according to a modification of the fourteenth embodiment.

Fig. 28 is a diagram illustrating a substantial configuration of a comparator circuit according to a fifteenth embodiment.

Fig. 29 is a diagram illustrating a substantial configuration of a comparator circuit according to a modification of the fifteenth embodiment.

Fig. 30 is a diagram illustrating a substantial configuration of a comparator circuit according to a sixteenth embodiment.

Fig. 31 is a diagram illustrating a substantial configuration of a comparator circuit according to a first modification of the sixteenth embodiment.

Fig. 32 is a diagram illustrating a substantial configuration of a comparator circuit according to a second modification of the sixteenth embodiment.

Fig. 33 is a diagram illustrating a substantial configuration of a comparator circuit according to a third modification of the sixteenth embodiment.

Fig. 34 is a diagram illustrating a substantial configuration of a comparator circuit according to a fourth modification of the sixteenth embodiment.

Fig. 35 is a diagram illustrating a substantial configuration of a comparator circuit according to a fifth modification of the sixteenth embodiment.

Fig. 36 is a diagram illustrating a substantial configuration of a comparator circuit according to a seventeenth embodiment.

Fig. 37 is a time chart for comparing operations at the time of inversion of the comparator circuit according to the seventh embodiment and the comparator circuit according to the seventeenth embodiment.

Fig. 38 is a diagram illustrating a substantial configuration of a comparator circuit according to a modification of the seventeenth embodiment.

Fig. 39 is a diagram illustrating a substantial configuration of a comparator circuit according to an eighteenth embodiment.

Fig. 40 is a diagram illustrating a substantial configuration of a comparator circuit according to a modification of the eighteenth embodiment.

Fig. 41 is a diagram illustrating a substantial configuration of a comparator circuit according to a nineteenth embodiment.

Fig. 42 is a diagram illustrating a substantial configuration of a comparator circuit according to a twentieth embodiment.

MODE FOR CARRYING OUT THE INVENTION

Hereinafter, an embodiment of the present disclosure will be described in detail with reference to the drawings. Note that, in the drawings, the same or corresponding elements are denoted by the same reference numerals, and detailed description thereof is omitted as appropriate.

[First Embodiment]

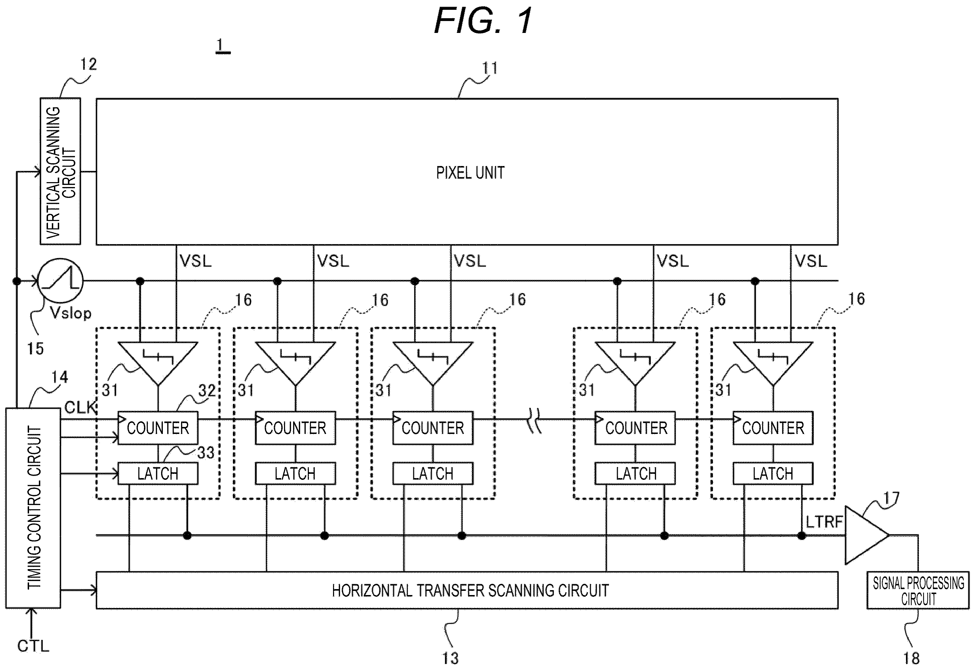

Fig. 1 is a diagram illustrating a configuration of an imaging device 1 according to a first embodiment of the present disclosure. The imaging device 1 is configured as a complementary metal oxide semiconductor (CMOS) image sensor, and includes a pixel unit 11, a vertical scanning circuit 12, a horizontal transfer scanning circuit 13, a timing control circuit 14, a digital to analog (D/A) converter 15, a plurality of A/D converters 16, an amplifier circuit 17, and a signal processing circuit 18.

Among these components, the pixel unit 11, the vertical scanning circuit 12, the horizontal transfer scanning circuit 13, the D/A converter 15, the plurality of A/D converters 16, and the amplifier circuit 17 are mainly configured by analog circuits. In contrast, the timing control circuit 14 and the signal processing circuit 18 are mainly configured by a digital circuit.

The pixel unit 11 is configured by arranging a plurality of pixels in a matrix. Since the configuration of the pixel unit 11 is similar to that of the conventional CMOS image sensor, detailed description thereof is omitted. The vertical scanning circuit 12 controls a row address and row scanning. The horizontal transfer scanning circuit 13 controls a column address and column scanning.

The timing control circuit 14 generates an internal clock for sequentially reading signals of the pixel unit 11. Furthermore, the timing control circuit 14 generates a timing signal necessary for an operation of the pixel unit 11, the vertical scanning circuit 12, the horizontal transfer scanning circuit 13, the D/A converter 15, the plurality of A/D converters 16, and the signal processing circuit 18.

The D/A converter 15 outputs a reference voltage Vslop, which is an analog ramp waveform, on the basis of the timing signal input from the timing control circuit 14.

The plurality of A/D converters 16 is arranged to form a column with respect to the pixel unit 11. The A/D converter 16 of each column performs A/D conversion using the reference voltage Vslop output from the D/A converter 15 on a pixel signal VSL read for each row from the pixel unit 11 and outputs a digital signal of a few bits.

Specifically, the A/D converter 16 includes a comparator circuit 31, a counter circuit 32, and a latch 33. The comparator circuit 31 compares the reference voltage Vslop output from the D/A converter 15 with the pixel signal VSL read for each row from the pixel unit 11. At that time, a count value of the counter circuit 32 changes while making a one-to-one correspondence with the ramp waveform of the reference voltage Vslop, whereby the pixel signal VSL is converted into a digital signal. Then, at a timing when the ramp waveform intersects with the pixel signal VSL, an output of the comparator circuit 31 is inverted and an input clock to the counter circuit 32 is stopped. Finally, the count value of the counter circuit 32 is held by the latch 33, whereby the A/D conversion is completed.

After the A/D conversion ends, data held in the latch 33 is transferred to a horizontal transfer line LTRF. The data transferred to the horizontal transfer line LTRF is amplified by the amplifier circuit 17, input to the signal processing circuit 18, and subjected to predetermined signal processing, whereby a two-dimensional image is generated.

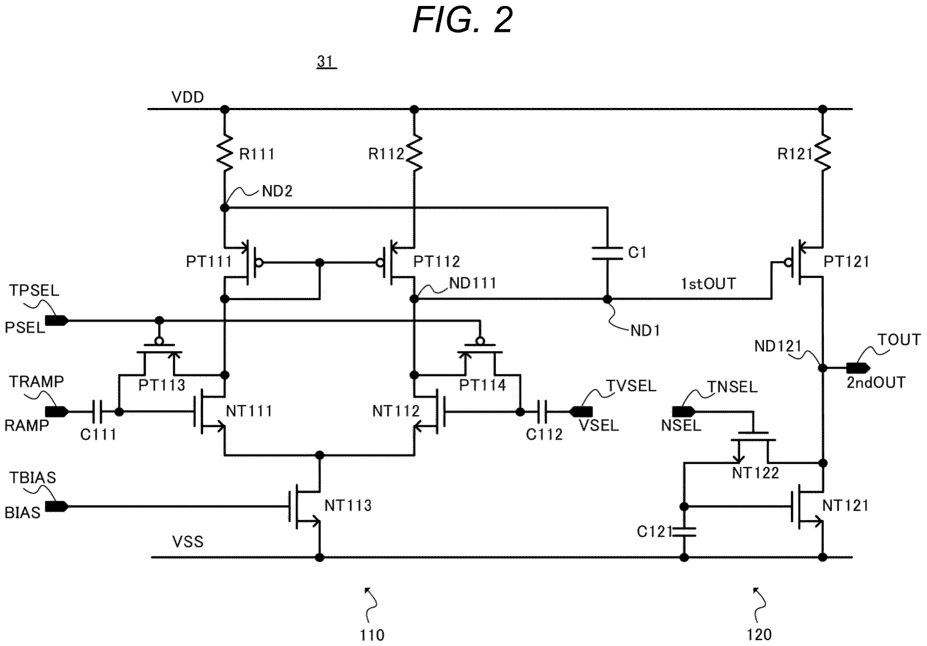

Fig. 2 is a diagram illustrating a detailed configuration of the comparator circuit 31 included in the A/D converter 16 of the imaging device 1. The comparator circuit 31 includes a first amplifier circuit 110 and a second amplifier circuit 120 provided at a subsequent stage of the first amplifier circuit 110.

The first amplifier circuit 110 is a differential amplifier circuit that compares the reference voltage Vslop (ramp signal RAMP) with the pixel signal VSL, and outputs a first output signal 1stOUT. The second amplifier circuit 120 amplifies the first output signal 1stOUT output from the first amplifier circuit 110 and outputs a second output signal 2ndOUT. The second output signal 2ndOUT output from the second amplifier circuit 120 is the output of the comparator circuit 31.

The first amplifier circuit 110 includes P-channel MOS (PMOS) transistors PT111 to PT114, N-channel MOS (NMOS) transistors NT111 to NT113, capacitors C111 to C112, and resistors R111 to R112.

In the first amplifier circuit 110, the PMOS transistors PT111 and PT112 configure a current mirror circuit on a power supply potential VDD side. A differential pair with the NMOS transistor NT113 as a current source is configured by the NMOS transistors NT111 and NT112 on a downstream side of the current mirror circuit.

One end of the resistor R111, which is a "resistance element" in the first embodiment, is directly connected to the power supply potential VDD. The other end of the resistor R111 is connected to a source of the PMOS transistor PT111, and a second node ND2 is formed by a connection point thereof (a first node ND1 will be described later). One end of the resistor R112 is directly connected to the power supply potential VDD. The other end of the resistor R112 is connected to a source of the PMOS transistor PT112.

The PMOS transistor PT111 is diode-connected, that is, a gate and a drain thereof are connected. The gate of the PMOS transistor PT111 is connected to a gate of the PMOS transistor PT112.

The drain of the PMOS transistor PT111 is connected to a drain of the NMOS transistor NT111. A drain of the PMOS transistor PT112 is connected to a drain of the NMOS transistor NT112 and a node ND111 is formed by a connection point thereof. The node ND111 serves as an output unit of the first amplifier circuit 110.

Sources of the NMOS transistors NT111 and NT112 are connected to each other, and a connection point thereof is connected to a drain of the NMOS transistor NT113. A source of the NMOS transistor NT113 is connected to reference potential VSS. A gate of the NMOS transistor NT113 is connected to an input terminal TBIAS of a bias signal BIAS.

A gate of the NMOS transistor NT111 is connected to one end of the capacitor C111. The other end of the capacitor C111 is connected to an input terminal TRAMP of the ramp signal RAMP. A gate of the NMOS transistor NT112 is connected to one end of the capacitor C112. The other end of the capacitor C112 is connected to an input terminal TVSL of the pixel signal VSL.

A source of the PMOS transistor PT113 is connected to the drain of the NMOS transistor NT111. A drain of the PMOS transistor PT113 is connected to the gate of the NMOS transistor NT111. A source of the PMOS transistor PT114 is connected to the drain of the NMOS transistor NT112. A drain of the PMOS transistor PT114 is connected to the gate of the NMOS transistor NT112.

Gates of the PMOS transistors PT113 and PT114 are commonly connected to an input terminal TPSEL of a first auto zero (AZ) signal PSEL active at a low level. The PMOS transistors PT113 and PT114 function as AZ switches, and the capacitors C111 and C112 function as AZ-level sampling capacitances.

As described above, in the first amplifier circuit 110, the PMOS transistors PT111 and PT112 configure the current mirror circuit on the power supply potential VDD side, and the NMOS transistors NT111 and NT112 configure the differential pair on the downstream side of the current mirror circuit. The first output signal 1stOUT output from the node ND111, which is the output unit of the first amplifier circuit 110, is input to the second amplifier circuit 120.

The second amplifier circuit 120 includes a PMOS transistor PT121, NMOS transistors NT121 to NT122, a capacitor C121, and a resistor R121. In the second amplifier circuit 120, the PMOS transistor PT121 functions as an amplifier element, and a gate of the PMOS transistor PT121 serves as an input unit of the second amplifier circuit 120.

One end of the resistor R121 is connected to the power supply potential VDD. The other end of the resistor R121 is connected to a source of the PMOS transistor PT121. A drain of the PMOS transistor PT121 is connected to a drain of the NMOS transistor NT121 and a node ND121 is formed by a connection point thereof. The node ND121 serves as an output unit of the second amplifier circuit 120.

A source of the NMOS transistor NT121 is connected to the reference potential VSS. A gate of the NMOS transistor NT121 is connected to one end of the capacitor C121. The other end of the capacitor C121 is connected to the reference potential VSS.

A drain of the NMOS transistor NT122 is connected to the drain of the NMOS transistor NT121. A source of the NMOS transistor NT122 is connected to the gate of the NMOS transistor NT121. A gate of the NMOS transistor NT122 is connected to an input terminal TNSEL of a second AZ signal NSEL active at a high level. The second AZ signal NSEL has a level complementary to that of the first AZ signal PSEL supplied to the first amplifier circuit 110. The NMOS transistor NT122 functions as the AZ switch, and the capacitor C121 functions as the sampling capacitance.

As described above, in the second amplifier circuit 120, the PMOS transistor PT121 functions as an amplifier element. The second output signal 2ndOUT output from the node ND121, which is the output unit of the second amplifier circuit 120, is output to an output terminal TOUT of the comparator circuit 31.

The first node ND1 is formed between the node ND111, which is the output unit of the first amplifier circuit 110, and the gate of the PMOS transistor PT121, which is the input unit of the second amplifier circuit 120. One end of a band limiting capacitor C1 is connected to the first node ND1. The other end of the band limiting capacitor C1 is connected to the second node ND2 of the first amplifier circuit 110 described above.

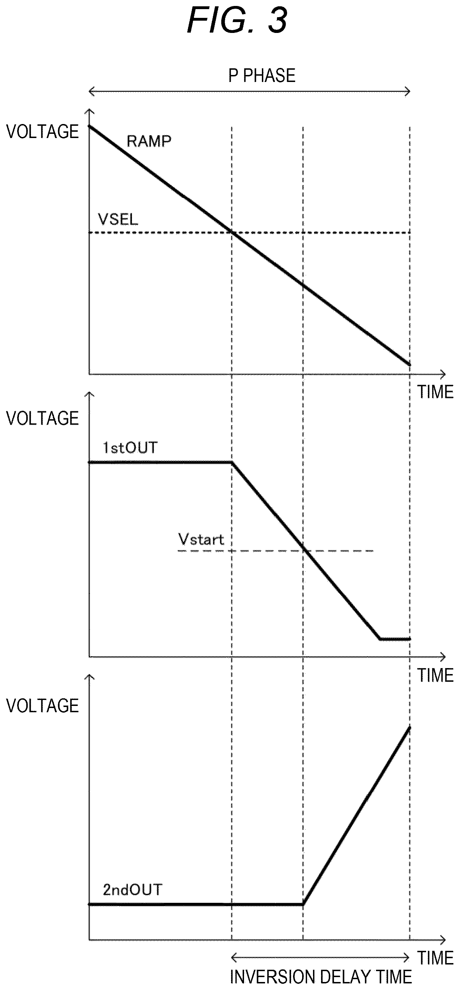

Fig. 3 is a time chart for describing an operation of the comparator circuit 31 at the time of inversion. Although detailed description is omitted, when an AZ period not illustrated ends, an integral A/D conversion (P phase) of a reset level is started.

In the P phase, comparison with the pixel signal VSL is performed following a change in the ramp waveform of the ramp signal RAMP. When the ramp signal RAMP intersects with the pixel signal VSL, a voltage level of the first output signal 1stOUT starts to decrease. When the voltage level of the first output signal 1stOUT decreases to an inversion start voltage Vstart, inversion of the second output signal 2ndOUT starts, and the second output signal 2ndOUT is inverted from a low level (L) to a high level (H).

In Fig. 3, a time required from when RAMP = VSL is satisfied and the voltage level of the first output signal 1stOUT starts to decrease to when the inversion of the second output signal 2ndOUT is completed is referred to as an "inversion delay time".

Next, a slew rate of the comparator circuit 31 according to the first embodiment will be described. Before that, a slew rate of a comparator circuit according to the conventional technology will be described, and the conventional technology is compared with the first embodiment.

(Slew Rate of Conventional Technology)

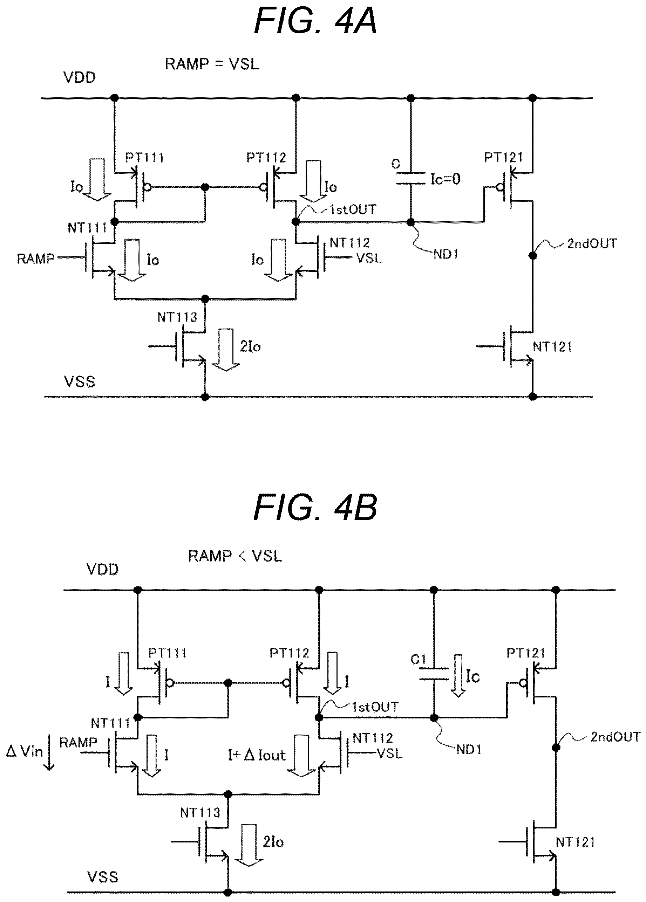

Figs. 4A and 4B are diagrams for describing the slew rate of the comparator circuit according to the conventional technology. The comparator circuit according to the conventional technology does not include the resistors R111 to R113 included in the first embodiment. Furthermore, one end of the band limiting capacitor C is connected to the first node ND1 similarly to the first embodiment, but the other end of the band limiting capacitor C is directly connected to the power supply potential VDD.

Fig. 4A illustrates magnitude of a current flowing through each transistor and the band limiting capacitor C in a case of RAMP = VSL in the comparator circuit according to the conventional technology. Assuming that a current flowing through the NMOS transistor NT113 of the current source is 2Io, in a case of RAMP = VSL, currents flowing through the NMOS transistors NT111 and NT112 configuring the differential pair are equal to each other and Io. Therefore, currents flowing through the PMOS transistors PT111 and PT112 configuring the current mirror circuit are also equal to each other and Io, and a current Ic flowing through the band limiting capacitor C = 0. The slew rate of 1stOUT at that time is SR = Ic/C = 0 (outputs are balanced).

Fig. 4B illustrates the magnitude of the current flowing through each transistor and the band limiting capacitor C in a case of RAMP < VSL in the comparator circuit according to the conventional technology. Assuming that VSL - RAMP = $\Delta$Vin, the current flowing through the NMOS transistor NT111 is I (<Io), and the current flowing through the NMOS transistor NT112 is I+$\Delta$Iout (>Io). At that time, the current flowing through the PMOS transistor PT111, which is a mirror source of the current mirror circuit, is I, and the current flowing through the PMOS transistor PT112, which is a mirror destination of the current mirror circuit, is also I. Therefore, the current Ic flowing through the band limiting capacitor C = $\Delta$Iout, and potential of the node of 1stOUT decreases. The slew rate SR of 1stOUT at that time is SR = Ic/C = $\Delta$Iout/C.

(Slew Rate of First Embodiment)

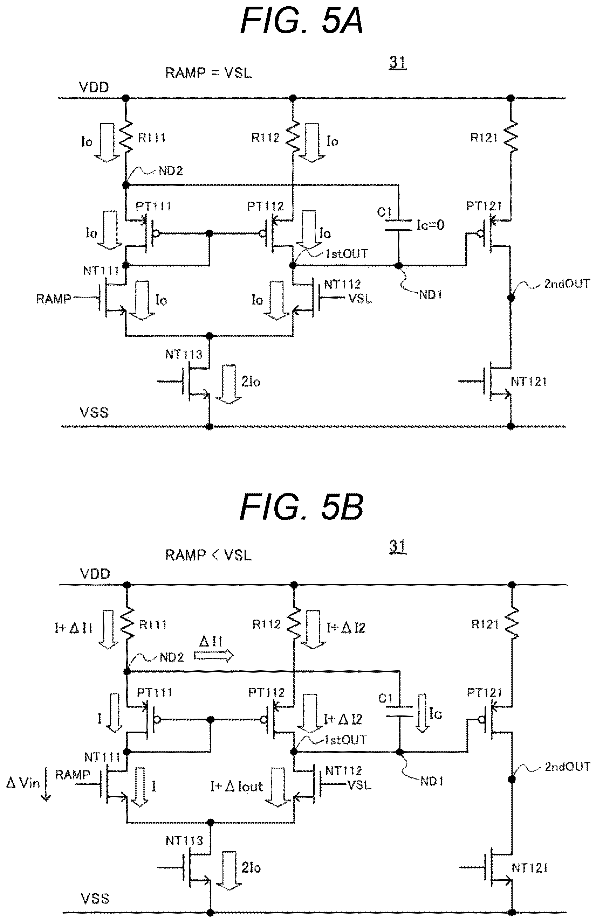

Figs. 5A and 5B are diagrams for describing the slew rate of the comparator circuit 31 according to the first embodiment. As described above, the comparator circuit 31 according to the first embodiment includes the resistors R111 to R113 provided between the power supply potential VDD and the current mirror circuit, and one ends of the resistors R111 to R113 are directly connected to the power supply potential VDD. The other end of the band limiting capacitor C1 is connected to the second node ND2 formed on the other end of the resistor R111, which is the "resistance element" in the first embodiment.

Fig. 5A illustrates the magnitude of the current flowing through each transistor and the band limiting capacitor C1 in a case of RAMP = VSL in the comparator circuit according to the first embodiment. Assuming that a current flowing through the NMOS transistor NT113 of the current source is 2Io, in a case of RAMP = VSL, currents flowing through the NMOS transistors NT111 and NT112 configuring the differential pair are equal to each other and Io. Furthermore, the currents flowing through the PMOS transistors PT111 and PT112 configuring the current mirror circuit are also equal to each other and Io, and the currents flowing through the resistors R111 and R112 connected between the power supply potential VDD and the current mirror circuit are also equal to each other and Io. Therefore, the current Ic flowing through the band limiting capacitor C1 = 0. The slew rate of 1stOUT at that time is SR = Ic/C1 = 0 (outputs are balanced).

Fig. 5B illustrates the magnitude of the current flowing through each transistor and the band limiting capacitor C1 in a case of RAMP < VSL in the comparator circuit according to the first embodiment. Assuming that VSL - RAMP = $\Delta$Vin, the current flowing through the NMOS transistor NT111 is I (<Io), and the current flowing through the NMOS transistor NT112 is I+$\Delta$Iout (>Io). At that time, the current of I flows through the PMOS transistor PT111. Furthermore, assuming that the current flowing through the resistor R111 is I+$\Delta$I1 and the current flowing through the resistor R112 is I+$\Delta$I2, the current Ic flowing through the band limiting capacitor C1 = $\Delta$I1, and the current of I+A2 flows through the PMOS transistor PT112.

Here, when a resistance value of the resistors R111 and R112 is denoted by Rs, and transconductance of the PMOS transistors PT111 and PT112 is denoted by gm, the following relational expression is established between the current Ic flowing through the band limiting capacitor C1 and $\Delta$Iout.

$$Ic = \Delta Iout/(1 + Rs \cdot gm/(1 + gm \cdot Rs)) \quad (1)$$

Furthermore, when the resistance value Rs of the resistors R111 and R112 is set so that Rs = 1/gm is established, expression (1) is as follows.

$$Ic = \Delta Iout \cdot (2/3) \qquad\qquad (2)$$

Expression (2) described above means that, in the comparator circuit 31 according to the first embodiment, the magnitude of the current Ic flowing through the band limiting capacitor C1 decreases to 2/3 of Ic = Iout in the conventional technology. Since the slew rate of 1stOUT is given by SR = Ic/C1, this means that, in the comparator circuit 31 according to the first embodiment, the capacitance of the band limiting capacitor C1 necessary for obtaining the same slew rate as that of the conventional technology may be 2/3 of that of the conventional technology. In general, since the capacitance of the capacitor is proportional to a size, in the comparator circuit 31 according to the first embodiment, the size of the band limiting capacitor C1 necessary for obtaining the same slew rate as that of the conventional technology is 2/3 of that of the conventional technology.

As described above, the comparator circuit 31 of the imaging device 1 according to the first embodiment includes the band limiting capacitor C1 provided between the output unit of the first amplifier circuit 110 and the input unit of the second amplifier circuit 120, and the resistor R111 as the resistance element with one end connected to the power supply potential VDD. One end of the band limiting capacitor C1 is connected to the first node ND1 formed between the output unit of the first amplifier circuit 110 and the input unit of the second amplifier circuit 120. The other end of the band limiting capacitor C1 is connected to a second node ND2 formed on the other end of the resistor R111 as the resistance element.

With the above-described feature, the imaging device 1 according to the first embodiment can reduce the size of the band limiting capacitor C1 while maintaining the slew rate of the comparator circuit 31. In other words, the slew rate of the comparator circuit 31 can be reduced without changing the size of the band limiting capacitor C1.

Note that, in the first embodiment, the resistance element is a single resistor, but the resistance element may be configured by a plurality of resistors connected in series, and the other end of the band limiting capacitor C1 may be connected to the middle or a terminal of the plurality of resistors. In this case, the relationship between the current Ic flowing through the band limiting capacitor C1 and ΔIout is as follows, when the number of connected resistors is M, the other end of the band limiting capacitor C1 is connected in the middle thereof, and the number of connected resistors on the power supply potential VDD side as seen from the connection point is N ($\leq$ M).

$$Ic = \Delta Iout/(1 + N \cdot M \cdot Rs \cdot gm/(1 + gm \cdot M \cdot Rs)) \qquad (3)$$

[Second Embodiment]

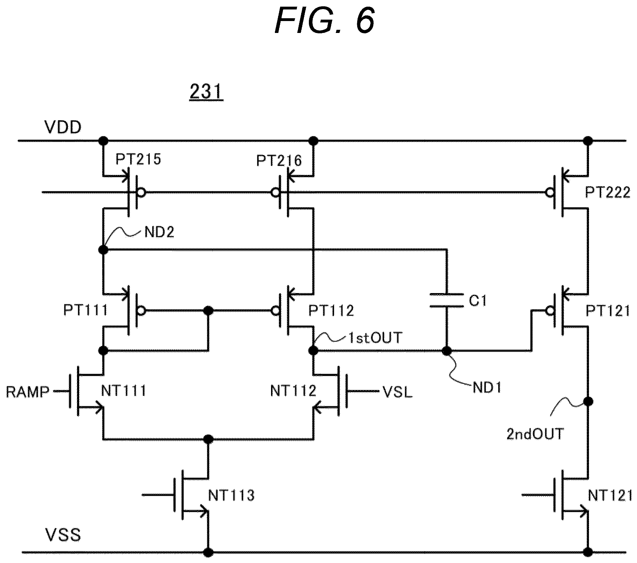

Fig. 6 is a diagram illustrating a substantial configuration of a comparator circuit 231 of an imaging device according to a second embodiment of the present disclosure. Note that, in the following description, portions different from those of the first embodiment will be mainly described, and configurations same as or similar to those of the first embodiment will be appropriately omitted.

The comparator circuit 231 according to the second embodiment is obtained by replacing the resistor connected to the power supply potential VDD with a PMOS transistor operating in a triode region in the comparator circuit 31 according to the first embodiment described above.

Specifically, a PMOS transistors PT215 is connected between the power supply potential VDD and the PMOS transistor PT111 in place of the resistor R111 of the first embodiment. The PMOS transistor PT215 is a "resistance element" in the second embodiment. Specifically, a PMOS transistors PT216 is connected between the power supply potential VDD and the PMOS transistor PT112 in place of the resistor R112 of the first embodiment. The PMOS transistors PT215 and PT216 are set to operate in the triode region.

Furthermore, a PMOS transistors PT222 is connected between the power supply potential VDD and the PMOS transistor PT121 in place of the resistor R121 of the first embodiment. The PMOS transistors PT222 is set to operate in the triode region.

The other end of the band limiting capacitor C1 is connected to a drain of the PMOS transistor PT215 as the resistance element. In the comparator circuit 231 according to the second embodiment also, a discussion similar to that of the comparator circuit 31 according to the first embodiment described above is established, and effects similar to those of the comparator circuit 31 according to the first embodiment can be obtained.

[Third Embodiment]

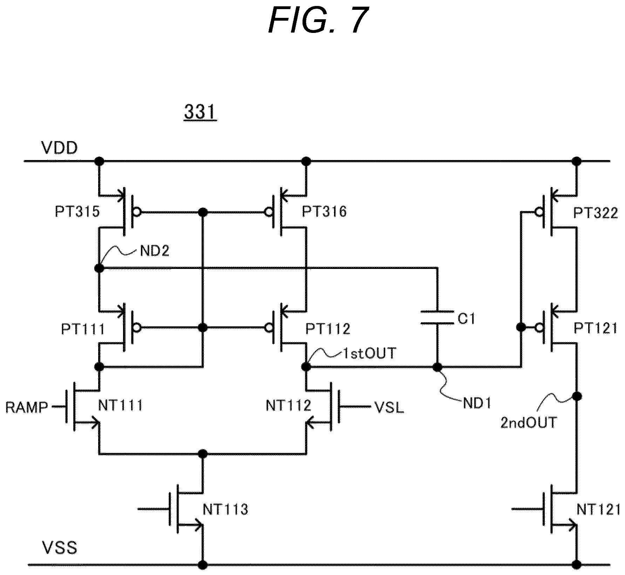

Fig. 7 is a diagram illustrating a substantial configuration of a comparator circuit 331 of an imaging device according to a third embodiment of the present disclosure.

The comparator circuit 331 according to the third embodiment is obtained by configuring a two-stage connection current mirror circuit by an existing current mirror circuit and a PMOS transistor provided between the same and the power supply potential VDD in the comparator circuit 231 according to the second embodiment described above.

Specifically, a PMOS transistors PT315 is connected between the power supply potential VDD and a PMOS transistor PT111. The PMOS transistor PT315 is a "resistance element" in the third embodiment. A PMOS transistor PT316 is connected between the power supply potential VDD and a PMOS transistor PT112. Gates of the PMOS transistors PT315 and PT316 are connected to each other, and a connection point thereof is connected to a connection point between gates of the PMOS transistors PT111 and PT112.

The PMOS transistors PT111 and PT112 configuring the existing current mirror circuit and the PMOS transistors PT315 and PT316 directly connected to the power supply potential VDD configure the two-stage connection current mirror circuit.

Furthermore, a PMOS transistor PT322 is connected between the power supply potential VDD and the PMOS transistor PT121. A gate of the PMOS transistor PT322 is connected to a gate of the PMOS transistor PT121.

The other end of the band limiting capacitor C1 is connected to a drain of the PMOS transistor PT315 as the resistance element. In the comparator circuit 331 according to the third embodiment also, an effect similar to that of the comparator circuit 231 according to the second embodiment described above can be obtained.

Note that, although the PMOS transistors PT315 and PT316 may be operated in either a triode region or a saturation region, a band limiting effect can be further enhanced when they are operated in the saturation region. This is because output resistance when the PMOS transistor operates in the saturation region is larger than the output resistance when this operates in the triode region.

When the PMOS transistors PT315 and PT316 are operated in the triode region, standard Vth PMOS transistors are used as the PMOS transistors PT315 and PT316, and low Vth PMOS transistors are used as the PMOS transistors PT111 and PT112. Alternatively, an aspect ratio W/L of the PMOS transistors PT315 and PT316 is set to be smaller than an aspect ratio W/L of the PMOS transistors PT311 and PT312.

[Fourth Embodiment]

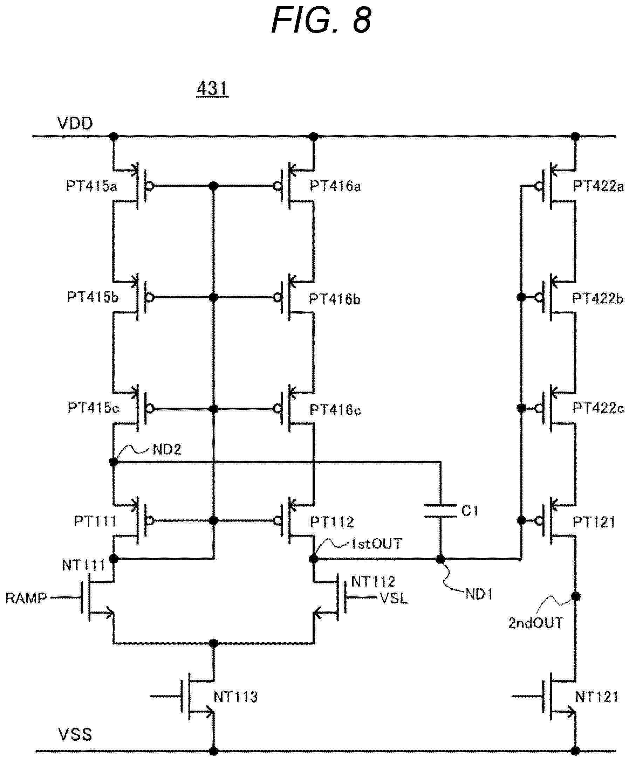

Fig. 8 is a diagram illustrating a substantial configuration of a comparator circuit 431 of an imaging device according to a fourth embodiment of the present disclosure.

The comparator circuit 431 according to the fourth embodiment is obtained by extending the two-stage connection current mirror circuit to an N-stage connection current mirror circuit in the comparator circuit 331 according to the third embodiment described above. Fig. 8 illustrates a case of N = 4.

Specifically, three PMOS transistors PT415a to PT415c are connected between power supply potential VDD and a PMOS transistor PT111. The PMOS transistors PT415a to PT415c are "resistance elements" in the fourth embodiment. Three PMOS transistors PT416a to PT416c are connected between the power supply potential VDD and a PMOS transistor PT112. Gates of three pairs of PMOS transistors PT415a to PT415c and PT416a to PT416c are connected to each other, and connection points thereof are connected to a connection point between gates of the PMOS transistors PT111 and PT112.

Furthermore, three PMOS transistors PT422a to PT422c are connected between the power supply potential VDD and the PMOS transistor PT121. Each gate of the PMOS transistors PT422a to PT422c is connected to a gate of the PMOS transistor PT121.

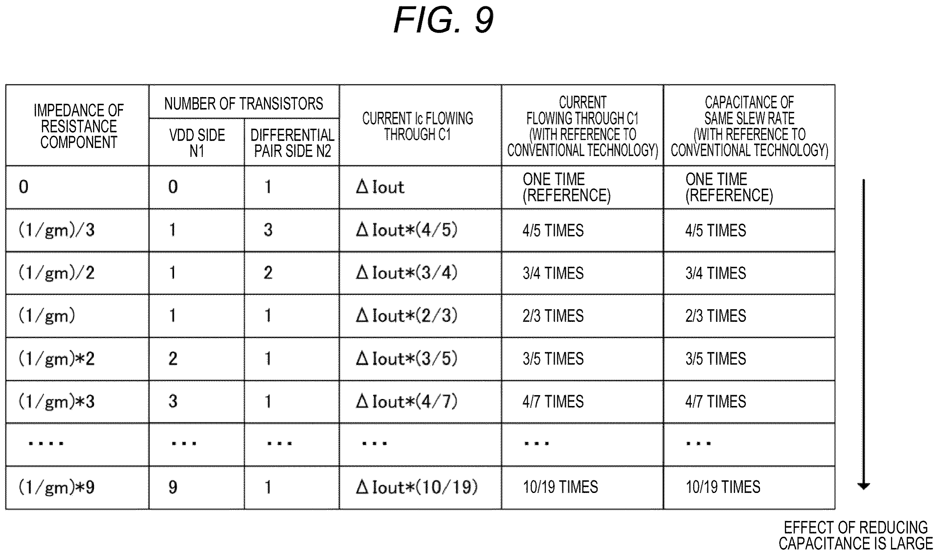

Here, the number of PMOS transistors existing between a second node ND2 to which the other end of a band limiting capacitor C1 is connected and the power supply potential VDD is set to N1, and the number of PMOS transistors existing between a second node ND2 and a differential pair is set to N2. In Fig. 8, N1 = 3 and N2 = 1. At that time, as for the capacitance of the band limiting capacitor C1 necessary for obtaining the same slew rate as that in the conventional technology, the relationship as illustrated in Fig. 9 is established.

With reference to Fig. 9, the capacitance of the band limiting capacitor C1 can be reduced by increasing either N1 or N2, but particularly by increasing N1, the capacitance, that is, the size of the band limiting capacitor C1 can be effectively reduced.

As described above, in the comparator circuit 431 according to the fourth embodiment, the resistance element to which the other end of the band limiting capacitor C1 is connected is a plurality of PMOS transistors PT415a to PT415c connected in multiple stages. The other end of the band limiting capacitor C1 is connected to the middle or a terminal of the plurality of PMOS transistors PT415a to PT415c connected in multiple stages. With such feature, in the fourth embodiment, the size of the band limiting capacitor C1 can be effectively reduced.

Note that, the PMOS transistors PT415c and PT416c may be operated in either the triode region or the saturation region, but the band limiting effect can be further enhanced when they are operated in the saturation region. This is because output resistance when the PMOS transistor operates in the saturation region is larger than the output resistance when this operates in the triode region. In this case, PT415a, PT415b, PT416a, and pT416b may be operated in either the triode region or the saturation region.

When the PMOS transistors PT415c and PT416c are operated in the triode region, standard Vth PMOS transistors are used as the PMOS transistors PT415c and PT416c, and low Vth PMOS transistors are used as the PMOS transistors PT111 and PT112. Alternatively, an aspect ratio W/L of the PMOS transistors PT415c and PT416c is set to be smaller than an aspect ratio W/L of the PMOS transistors PT311 and PT312.

[Fifth Embodiment]

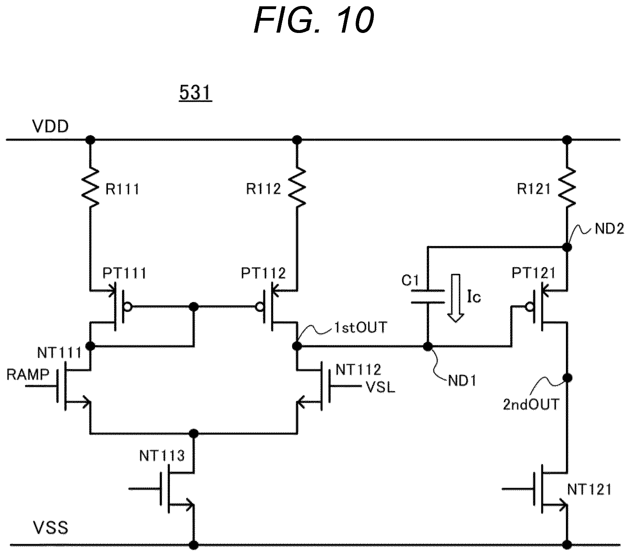

Fig. 10 is a diagram illustrating a substantial configuration of a comparator circuit 531 of an imaging device according to a fifth embodiment of the present disclosure.

The comparator circuit 531 according to the fifth embodiment is obtained by forming the second node ND2 to which the other end of the band limiting capacitor C1 is connected between the resistor R121 and a PMOS transistor PT211 in the comparator circuit 31 according to the first embodiment described above. The resistor R121 is a "resistance element" in the fifth embodiment.

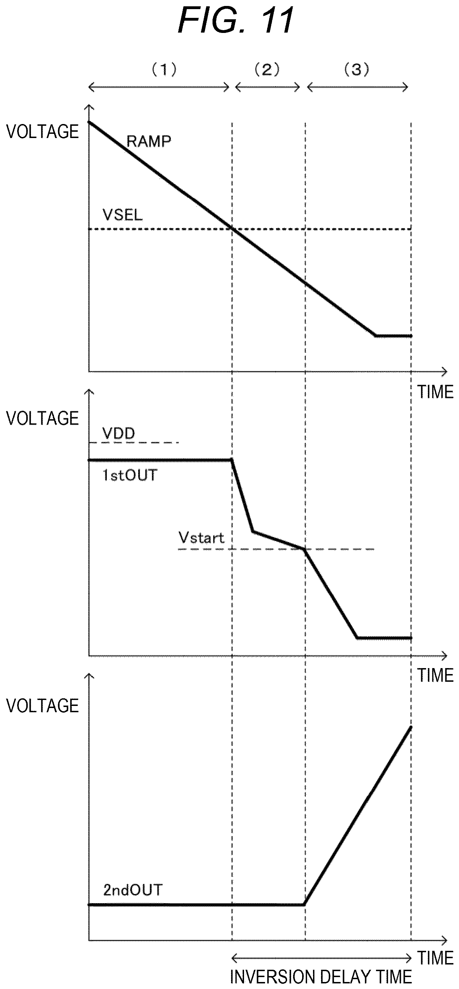

Fig. 11 is a time chart for describing an operation of the comparator circuit 531 at the time of inversion. First, in a period (1) in Fig. 11, RAMP >= VSL, a voltage level of the first output signal 1stOUT maintains a constant value slightly lower than the power supply potential VDD, and the band limiting capacitor C1 is charged by a potential difference between the power supply potential VDD and the first output signal 1stOUT. At that time, a current does not flow into the resistor R121 from the power supply potential VDD, and the current Ic of the band limiting capacitor C1 = 0.

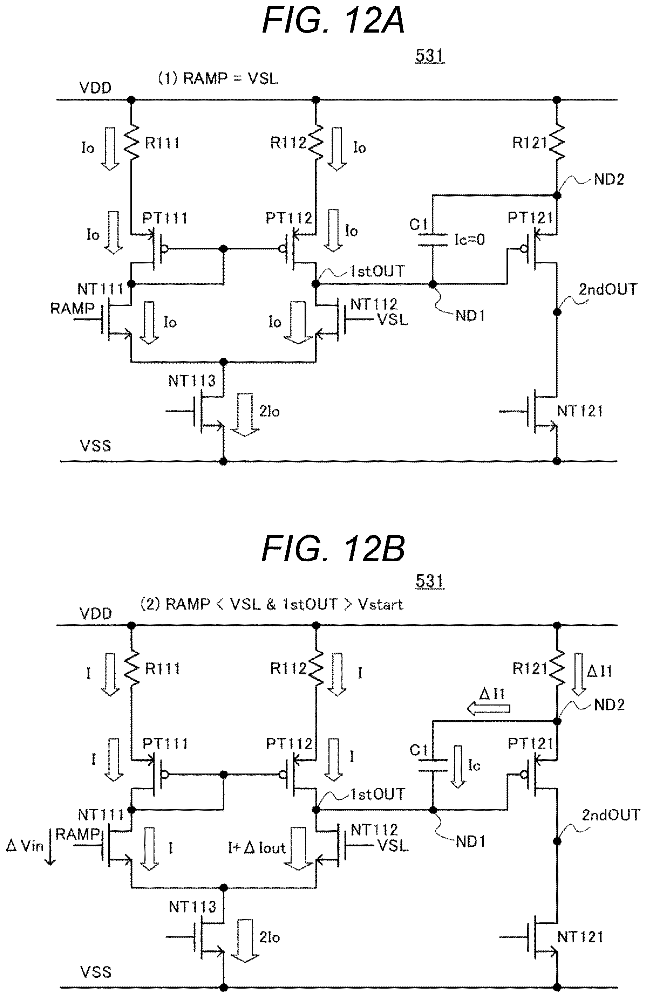

Fig. 12A illustrates the current flowing through each transistor and the band limiting capacitor C1 in a case of (1) RAMP = VSL in the comparator circuit 531. Assuming that a current flowing through the NMOS transistor NT113 of the current source is 2Io, in a case of RAMP = VSL, currents flowing through the NMOS transistors NT111 and NT112 configuring the differential pair are equal to each other and Io. Furthermore, the currents flowing through the PMOS transistors PT111 and PT112 configuring the current mirror circuit are also equal to each other and Io, and the currents flowing through the resistors R111 and R112 connected between the power supply potential VDD and the current mirror circuit are also equal to each other and Io. Therefore, the current Ic flowing through the band limiting capacitor C1 = 0.

Next, in a period (2) in Fig. 11, RAMP < VSL and 1stOUT > Vstart, the voltage level of the first output signal 1stOUT decreases, and the current flows from the power supply potential VDD to the capacitor C1 via the resistor R121. At that time, the band limiting capacitor C1 is discharged, so that the band is limited. Note that, since the voltage level of the first output signal 1stOUT is still higher than the inversion start voltage Vstart, no current flows through the PMOS transistor PT121, and the second output signal 2ndOUT remains at the low level (L).

Fig. 12B illustrates the current flowing through each transistor and the band limiting capacitor C1 in a case of (2) RAMP = VSL and 1stOUT > Vstart in the comparator circuit 531. Assuming that VSL - RAMP = $\Delta$Vin, the current flowing through the NMOS transistor NT111 is I (<Io), and the current flowing through the NMOS transistor NT112 is I+$\Delta$Iout (>Io). At that time, the current flowing through the PMOS transistor PT111, which is a mirror source of the current mirror circuit, is I, and the current flowing through the PMOS transistor PT112, which is a mirror destination of the current mirror circuit, is also I. Furthermore, when the current flowing from the power supply potential VDD to the resistor R121 is $\Delta$I1, since no current flows through the PMOS transistor PT121, $\Delta$I1 = Ic = $\Delta$Iout is satisfied.

Finally, in a period (3) in Fig. 11, RAMP < VSL and 1stOUT < Vstart, and the current flows through not only the band limiting capacitor C1 but also the PMOS transistor PT121. Therefore, the second output signal 2ndOUT is inverted from the low level (L) to the high level (H).

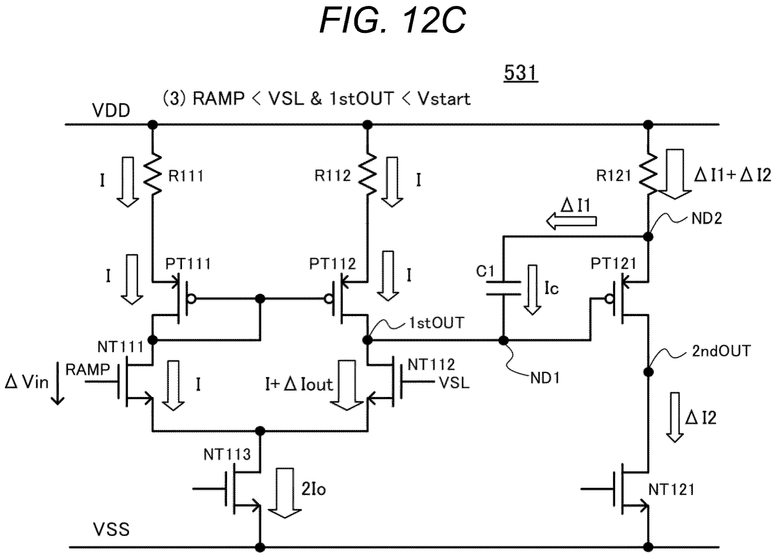

Fig. 12C illustrates the magnitude of the current flowing through each transistor and the band limiting capacitor C1 in a case of (3) RAMP < VSL and 1stOUT < Vstart in the comparator circuit 531. The current flowing from the power supply potential VDD into the resistor R121 is the sum of the current Ic = $\Delta$1 flowing through the capacitor and the current $\Delta$I2 flowing through the MOS transistor PT121. Here, when transconductance of the PMOS transistor PT121 is denoted gm, the following relational expression is established between $\Delta$I1 and $\Delta$I2.

$$\Delta I2 \;=\; gm \cdot \Delta I1 \cdot \Delta t / C \qquad\qquad (4)$$

Note that, in the above expression, $\Delta$t represents a length of the period (3) in Fig. 11, and C represents the capacitance of the band limiting capacitor C1.

As described above, in the comparator circuit 531 of the imaging device according to the fifth embodiment, the other end of the band limiting capacitor C1 is connected to the second node ND2 formed on the other end of the resistor R121 as the resistance element directly connected to the power supply potential VDD.

With the above-described feature, in the comparator circuit 531 according to the fifth embodiment, the band limiting capacitor C1 is discharged at the time of inversion, so that the output current $\Delta$I2 can be decreased and the band can be limited. Note that, in the fifth embodiment, the resistance element is a single resistor, but the resistance element may be configured by a plurality of resistors connected in series, and the other end of the band limiting capacitor C1 may be connected to the middle or a terminal of the plurality of resistors.

[Sixth Embodiment]

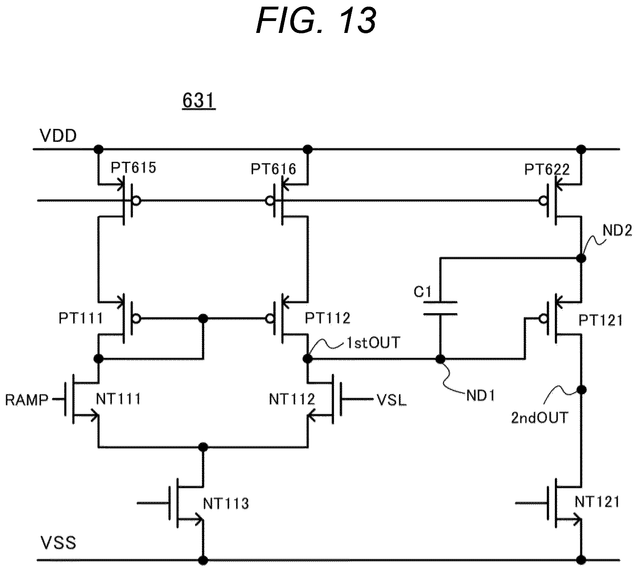

Fig. 13 is a diagram illustrating a substantial configuration of a comparator circuit 631 of an imaging device according to a sixth embodiment of the present disclosure.

The comparator circuit 631 according to the sixth embodiment is obtained by replacing the resistor connected to the power supply potential VDD with a PMOS transistor operating in a triode region in the comparator circuit 531 according to the fifth embodiment described above. The PMOS transistor PT622 is a "resistance element" in the sixth embodiment. Furthermore, the resistor connected between the power supply potential VDD and the current mirror circuit in the fifth embodiment is also replaced with the PMOS transistor operating in the triode region.

The other end of the band limiting capacitor C1 is connected to a drain of the PMOS transistor PT622 as the resistance element. In the comparator circuit 631 according to the sixth embodiment also, a discussion similar to that of the comparator circuit 531 according to the fifth embodiment described above is established, and effects similar to those of the comparator circuit 531 according to the fifth embodiment can be obtained.

[Seventh Embodiment]

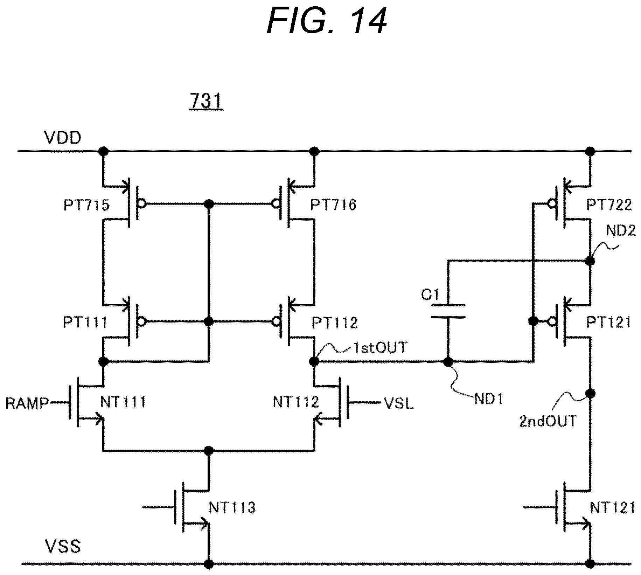

Fig. 14 is a diagram illustrating a substantial configuration of a comparator circuit 731 of an imaging device according to a seventh embodiment of the present disclosure.

The comparator circuit 731 according to the seventh embodiment is obtained by making two-stage connection by connecting the gate of the PMOS transistor 121, which is the existing amplifier element, and a gate of a PMOS transistor PT722 provided between the same and the power supply potential VDD in the comparator circuit 631 according to the sixth embodiment described above. The PMOS transistor PT722 is a "resistance element" in the seventh embodiment. The PMOS transistor PT722 may be operated in either a triode region or a saturation region. Furthermore, the PMOS transistors PT715 and PT716 and the existing current mirror circuit configure a two-stage connection current mirror circuit.

The other end of the band limiting capacitor C1 is connected to a drain of the PMOS transistor PT722 as the resistance element. In the comparator circuit 731 according to the seventh embodiment also, an effect similar to that of the comparator circuit 631 according to the sixth embodiment described above can be obtained.

[Eighth Embodiment]

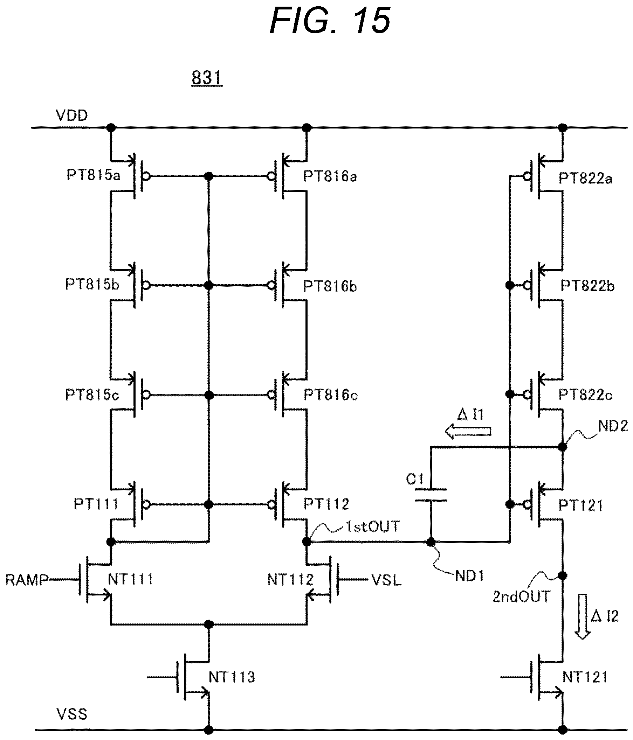

Fig. 15 is a diagram illustrating a substantial configuration of a comparator circuit 831 of an imaging device according to an eighth embodiment of the present disclosure.

The comparator circuit 831 according to the eighth embodiment is obtained by extending the two-stage connection to an N-stage connection in the comparator circuit 731 according to the seventh embodiment described above. Fig. 15 illustrates a case of N = 4.

Three PMOS transistors PT822a to PT822c are connected between the power supply potential VDD and the PMOS transistor PT121. The PMOS transistors PT822a to PT822c are "resistance elements" in the eighth embodiment. The PMOS transistors PT822a to PT822c may be operated in either a triode region or a saturation region.

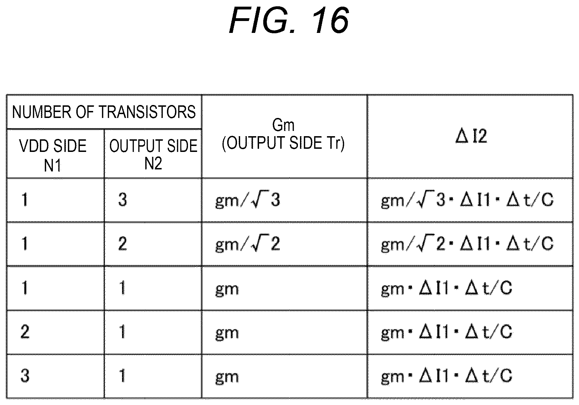

The number of PMOS transistors existing between a second node ND3 to which the other end of the band limiting capacitor C1 is connected and the power supply potential VDD is set to N1, and the number of PMOS transistors existing between the second node ND3 and the NMOS transistor NT121 as the current source is set to N2. In Fig. 15, N1 = 3 and N2 = 1. At that time, a relationship as illustrated in Fig. 16 is established between ΔI1 and ΔI2. With reference to Fig. 16, it can be seen that an output current change ΔI2 decreases and the inversion delay time becomes longer as N2 increases.

As described above, in the comparator circuit 831 according to the eighth embodiment, the resistance elements to which the other end of the band limiting capacitor C1 is connected are a plurality of PMOS transistors PT822a to PT822c connected in multiple stages. The second node ND2 to which the other end of the band limiting capacitor C1 is connected is formed in the middle or a terminal of the plurality of PMOS transistors PT822a to PT822c connected in multiple stages.

Note that, the relationship in Fig. 16 is similarly established even in a case where the resistance elements are configured by a plurality of resistors connected in series and the other end of the band limiting capacitor C1 is connected to the middle or terminal of the plurality of resistors in the fifth embodiment described above.

[Ninth Embodiment]

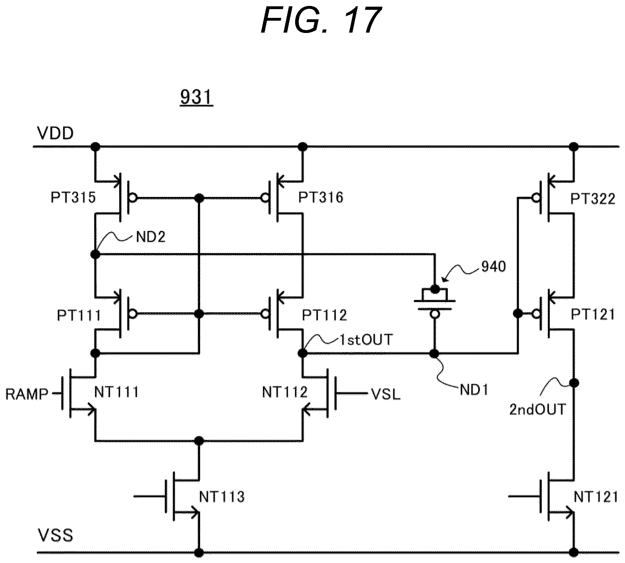

Fig. 17 is a diagram illustrating a substantial configuration of a comparator circuit 931 of an imaging device according to a ninth embodiment of the present disclosure.

As described above, the "inversion delay time" of the comparator circuit is a time required from when RAMP = VSL is satisfied and the voltage level of the first output signal 1stOUT starts to decrease to when the inversion of the second output signal 2ndOUT is completed (refer to Fig. 3). As a method of shortening the inversion delay time, for example, it is conceivable to further reduce the capacitance of the band limiting capacitor C1 to make an inclination of a change in voltage level of the first output signal 1stOUT steeper. However, only by simply reducing the capacitance of the band limiting capacitor C1, there is a possibility that a noise reduction effect at the time of inversion cannot be sufficiently obtained.

In the comparator circuit 931 according to the ninth embodiment, in order to shorten the inversion delay time while maintaining the noise reduction effect at the time of inversion, in the comparator circuit 331 according to the third embodiment described above, the band limiting capacitor C1 is configured by a MOSCAP 940. The MOSCAP is used as a capacitor while short-circuiting a drain and a source of a MOS transistor in which a gate serves as one terminal and the short-circuited drain and source serve as the other terminal.

In a case where a voltage across the MOSCAP 940, that is, Vgs, is smaller than a threshold voltage, no channel is formed between the source and drain, so that the capacitance thereof is mainly determined by a gate-substrate parasitic capacitance Cgb. In contrast, in a case where the voltage across the MOSCAP 940, that is, Vgs, is larger than the threshold, a channel is formed between the drain and source, so that the capacitance thereof is mainly determined by the sum of a gate-source parasitic capacitance Cgs and a gate-drain parasitic capacitance Cgd. In general, since Cgs + Cgd >> Cgb, the capacitance of the MOSCAP 940 is small in a case where the voltage across the same is smaller than the threshold voltage, and rapidly increases when the voltage across the same becomes larger than the threshold voltage.

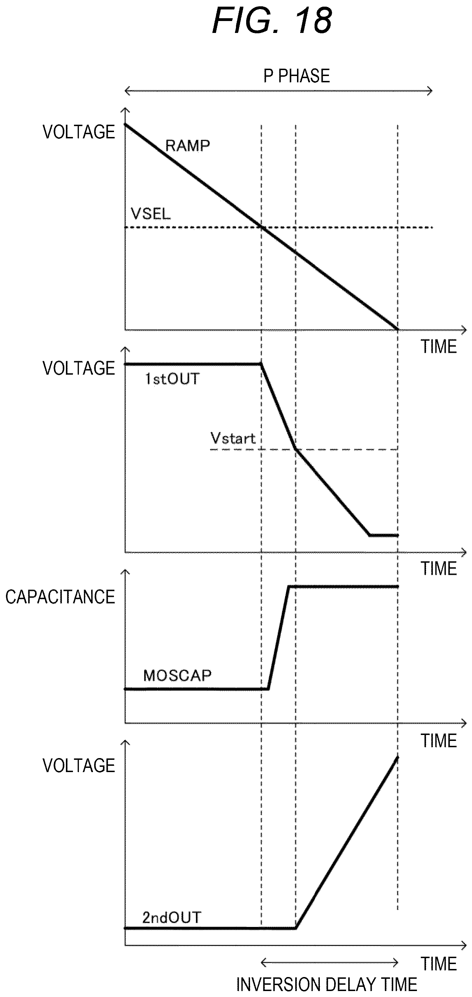

Fig. 18 is a time chart for describing an operation of the comparator circuit 931 according to the ninth embodiment at the time of inversion. The capacitance of the MOSCAP 940 is set to be small in a range in which the voltage level of the first output signal 1stOUT is higher than the inversion start voltage Vstart and to be large in a range in which the voltage level of the first output signal 1stOUT is lower than the inversion start voltage Vstart by adjusting the threshold voltage. Therefore, the inclination of the change in voltage level of the first output signal 1stOUT is steep until the inversion of the second output signal 2ndOUT is started, and becomes gentle after the inversion of the second output signal 2ndOUT is started. As a result, the inversion delay time is shortened while maintaining the noise reduction effect at the time of inversion.

As described above, in the comparator circuit 931 according to the ninth embodiment, the band limiting capacitor is configured by the MOSCAP 940. With such feature, in the comparator circuit 941 according to the ninth embodiment, the inversion delay time can be shortened while maintaining the noise reduction effect at the time of inversion.

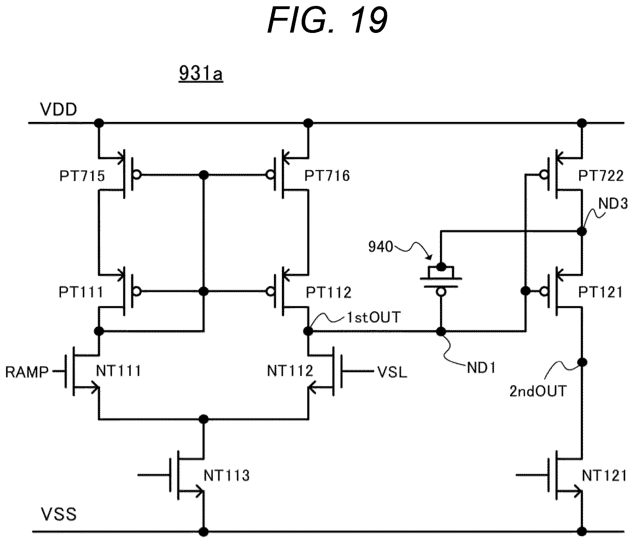

Note that, the technique of the MOSCAP according to the ninth embodiment can be similarly applied to other embodiments. For example, in Fig. 19, in the comparator circuit according to the seventh embodiment, the band limiting capacitor C1 is configured by the MOSCAP 940.

[Tenth Embodiment]

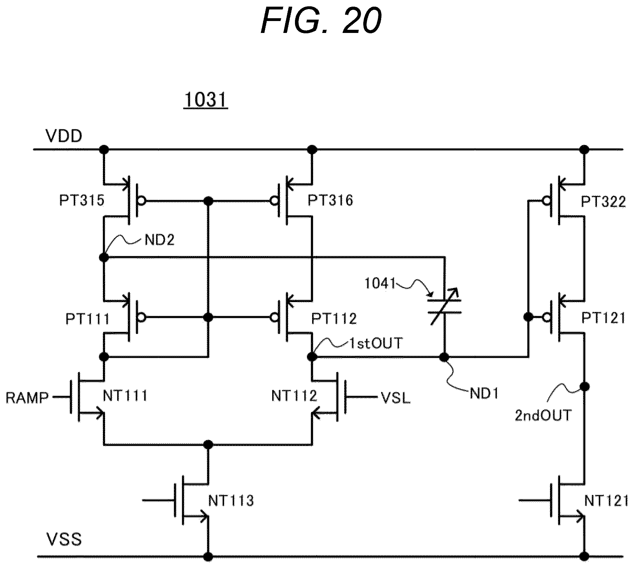

Fig. 20 is a diagram illustrating a substantial configuration of a comparator circuit 1031 of an imaging device according to a tenth embodiment of the present disclosure.

In the ninth embodiment described above, by replacing the band limiting capacitor with the MOSCAP, the inversion delay time is shortened while maintaining the noise reduction effect at the time of inversion. By the idea similar to this, in the comparator circuit 1031 according to the tenth embodiment, in the comparator circuit 331 according to the third embodiment described above, the band limiting capacitor C1 is configured by a variable capacitor 1041.

The capacitance of the variable capacitor 9041 is variably controlled by a control means not illustrated. Specifically, the control means reduces the capacitance of the variable capacitor 9041 in a range where the voltage level of the first output signal 1stOUT is higher than the inversion start voltage Vstart, and reduces the capacitance of the variable capacitor 9041 in a range where the voltage level of the first output signal 1stOUT is lower than the inversion start voltage Vstart.

Therefore, the inclination of the change in voltage level of the first output signal 1stOUT is steep until the inversion of the second output signal 2ndOUT is started, and becomes gentle after the inversion of the second output signal 2ndOUT is started. As a result, the inversion delay time is shortened while maintaining the noise reduction effect at the time of inversion.

As described above, in the comparator circuit 1031 according to the tenth embodiment, the band limiting capacitor is configured by the variable capacitor 1041. With such feature, in the comparator circuit 1031 according to the tenth embodiment, the inversion delay time can be shortened while maintaining the noise reduction effect at the time of inversion.

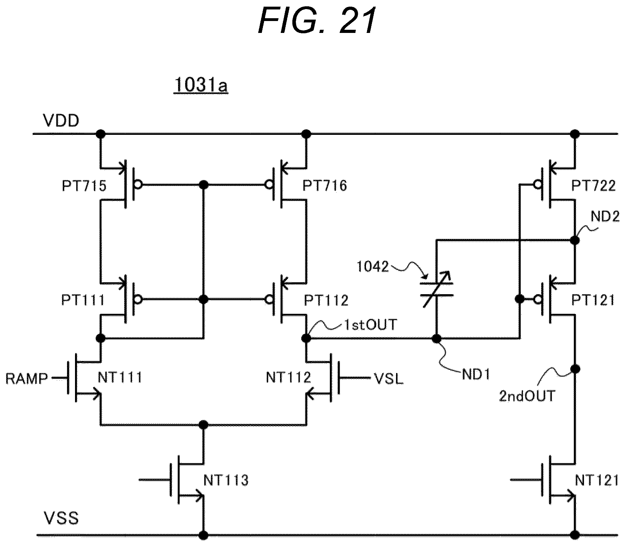

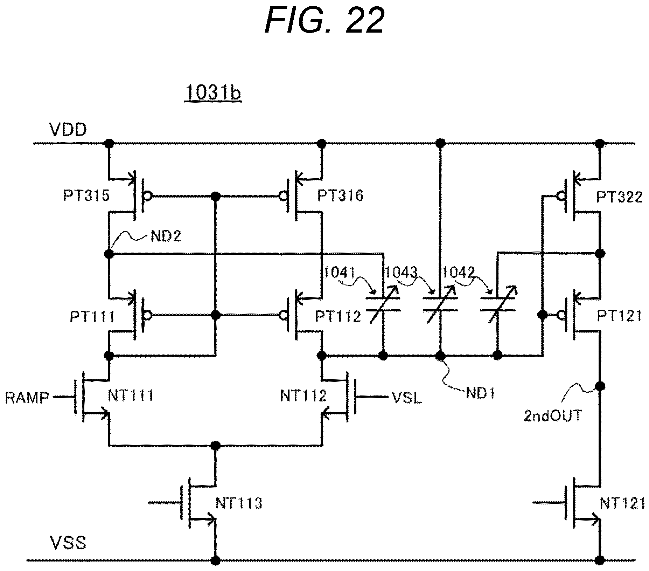

Note that, the technique according to the tenth embodiment can be similarly applied to other embodiments. For example, in Fig. 21, in the comparator circuit according to the seventh embodiment described above, the band limiting capacitor C1 is configured by the variable capacitor 1042. Furthermore, in Fig. 22, a plurality of variable capacitors is provided as the band limiting capacitor.

[Eleventh Embodiment]

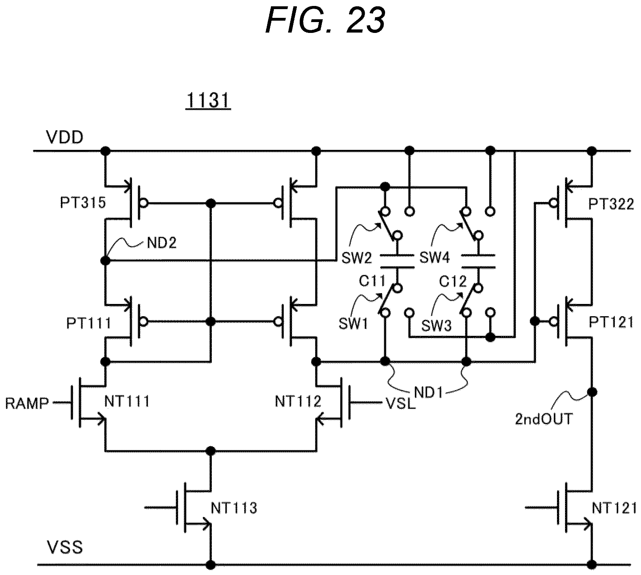

Fig. 23 is a diagram illustrating a substantial configuration of a comparator circuit 1131 of an imaging device according to an eleventh embodiment of the present disclosure.

In the comparator circuit 1131 according to the eleventh embodiment, in the comparator circuit 331 according to the third embodiment described above, the band limiting capacitor C1 is configured by two capacitors C11 and C12.

One end of the capacitor C11 is connected to a first changeover switch SW1. The first changeover switch SW1 switches a connection destination of one end of the capacitor C11 to either the first node ND1 or the power supply potential VDD. A switching state of the first changeover switch SW1 is controlled by a control means not illustrated.

The other end of the capacitor C11 is connected to a second changeover switch SW2. The second changeover switch SW2 switches a connection destination of the other end of the capacitor C11 to either the second node ND2 or the power supply potential VDD. A switching state of the second changeover switch SW2 is controlled by a control means not illustrated.

One end of the capacitor C12 is connected to a third changeover switch SW3. The third changeover switch SW3 switches a connection destination of one end of the capacitor C12 to either the first node ND1 or the power supply potential VDD. A switching state of the third changeover switch SW3 is controlled by a control means not illustrated.

The other end of the capacitor C12 is connected to a fourth changeover switch SW4. The fourth changeover switch SW4 switches a connection destination of the other end of the capacitor C12 to either the second node ND2 or the power supply potential VDD. A switching state of the fourth changeover switch SW4 is controlled by a control means not illustrated.

In a case where one end of the capacitor C11 is connected to the first node ND1 by the first changeover switch SW1 and the other end of the capacitor C11 is connected to the second node ND2 by the second changeover switch SW2, the capacitor C11 functions as the band limiting capacitor.

In contrast, in a case where one end of the capacitor C11 is connected to the power supply potential VDD by the first changeover switch SW1 and the other end of the capacitor C11 is connected to the power supply potential VDD by the second changeover switch SW2, the capacitor C11 does not function as the band limiting capacitor and can implement an operation equivalent to that of the conventional comparator circuit without the capacitor C11.

Similarly, in a case where one end of the capacitor C12 is connected to the first node ND1 by the third changeover switch SW3 and the other end of the capacitor C12 is connected to the second node ND2 by the fourth changeover switch SW4, the capacitor C12 functions as the band limiting capacitor.

In contrast, in a case where one end of the capacitor C12 is connected to the power supply potential VDD by the third changeover switch SW3 and the other end of the capacitor C12 is connected to the power supply potential VDD by the fourth changeover switch SW4, the capacitor C12 does not function as the band limiting capacitor and can implement an operation equivalent to that of the conventional comparator circuit without the capacitor C11.

The control means causes only the capacitor C11 to function as the band limiting capacitor in a range in which the voltage level of the first output signal 1stOUT is higher than the inversion start voltage Vstart, and causes the capacitor C12 to function as the band limiting capacitor in addition to the capacitor C11 in a range in which the voltage level of the first output signal 1stOUT is lower than the inversion start voltage Vstart.

Therefore, the inclination of the change in voltage level of the first output signal 1stOUT is steep until the inversion of the second output signal 2ndOUT is started, and becomes gentle after the inversion of the second output signal 2ndOUT is started. As a result, the inversion delay time is shortened while maintaining the noise reduction effect at the time of inversion.

As described above, in the comparator circuit 1031 according to the eleventh embodiment, the band limiting capacitor is configured by the two capacitors C11 and C12. The first to fourth changeover switches SW1 to SW4 switch connection destinations of both ends of the capacitors C11 and C12.

With such feature, in the comparator circuit 1131 according to the eleventh embodiment also, the inversion delay time can be shortened while maintaining the noise reduction effect at the time of inversion. Note that, the technique according to the eleventh embodiment can be similarly applied to other embodiments. Furthermore, the control means may control in such a manner that the setting of the band limiting capacitor is switched according to a required noise amount and is set to a fixed value during the A/D conversion.

[Twelfth Embodiment]

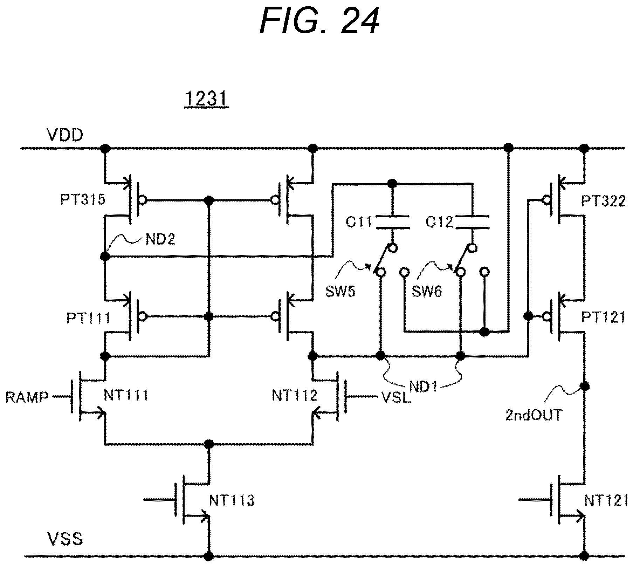

Fig. 24 is a diagram illustrating a substantial configuration of a comparator circuit 1231 of an imaging device according to a twelfth embodiment of the present disclosure.

In the comparator circuit 1231 according to the twelfth embodiment, the connection destination of the other end of each of the capacitors C11 and C12 is fixed to the second node ND2 in the eleventh embodiment described above. The connection destination of one end of each of the capacitors C11 and C12 is switched to either the first node ND1 or the power supply potential VDD.

Specifically, one end of the capacitor C11 is connected to a fifth changeover switch SW5. The fifth changeover switch SW5 switches the connection destination of one end of the capacitor C11 to either the first node ND1 or the power supply potential VDD. A switching state of the fifth changeover switch SW5 is controlled by a control means not illustrated. The connection destination of the other end of the capacitor C11 is fixed to the second node ND2.

One end of the capacitor C12 is connected to a sixth changeover switch SW6. The sixth changeover switch SW6 switches the connection destination of one end of the capacitor C12 to either the first node ND1 or the power supply potential VDD. A switching state of the sixth changeover switch SW6 is controlled by a control means not illustrated. The connection destination of the other end of the capacitor C12 is fixed to the second node ND2.

In a case where one end of the capacitor C11 is connected to the first node ND1 by the fifth changeover switch SW5, the capacitor C11 functions as the band limiting capacitor. In contrast, in a case where one end of the capacitor C11 is connected to the power supply potential VDD by the fifth changeover switch SW5, the capacitor C11 does not function as the band limiting capacitor.

Similarly, in a case where one end of the capacitor C12 is connected to the first node ND1 by the sixth changeover switch SW6, the capacitor C12 functions as the band limiting capacitor. In contrast, in a case where one end of the capacitor C12 is connected to the power supply potential VDD by the seventh changeover switch SW7, the capacitor C12 does not function as the band limiting capacitor.

The control means causes only the capacitor C11 to function as the band limiting capacitor in a range in which the voltage level of the first output signal 1stOUT is higher than the inversion start voltage Vstart, and causes the capacitor C12 to function as the band limiting capacitor in addition to the capacitor C11 in a range in which the voltage level of the first output signal 1stOUT is lower than the inversion start voltage Vstart.

Therefore, the inclination of the change in voltage level of the first output signal 1stOUT is steep until the inversion of the second output signal 2ndOUT is started, and becomes gentle after the inversion of the second output signal 2ndOUT is started. As a result, the inversion delay time is shortened while maintaining the noise reduction effect at the time of inversion.

As described above, in the comparator circuit 1231 according to the twelfth embodiment also, the inversion delay time can be shortened while maintaining the noise reduction effect at the time of inversion. Note that, the technique according to the twelfth embodiment can be similarly applied to other embodiments. Furthermore, the control means may control in such a manner that the setting of the band limiting capacitor is switched according to a required noise amount and is set to a fixed value during the A/D conversion.

[Thirteenth Embodiment]

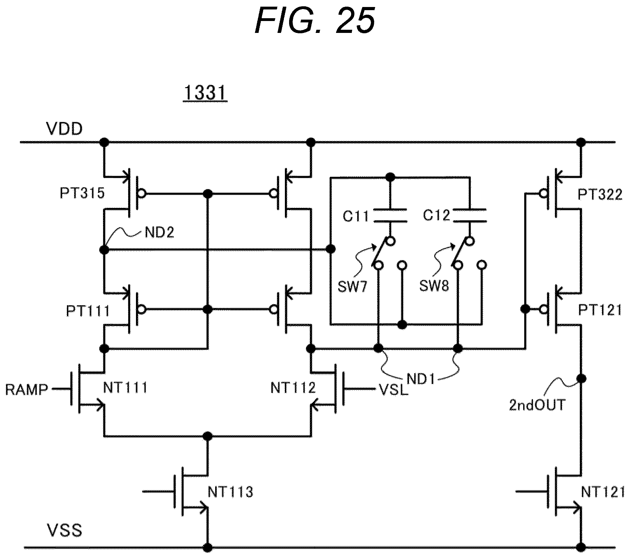

Fig. 25 is a diagram illustrating a substantial configuration of a comparator circuit 1331 of an imaging device according to a thirteenth embodiment of the present disclosure.

In the comparator circuit 1331 according to the thirteenth embodiment, the connection destination of one end of each of the capacitors C11 and C12 is switched to either the first node ND1 or the second node ND2 in the twelfth embodiment described above.

Specifically, one end of the capacitor C11 is connected to a seventh changeover switch SW7. The seventh changeover switch SW7 switches the connection destination of one end of the capacitor C11 to either the first node ND1 or the second node ND2. A switching state of the seventh changeover switch SW7 is controlled by a control means not illustrated. The connection destination of the other end of the capacitor C11 is fixed to the second node ND2.

One end of the capacitor C12 is connected to an eighth changeover switch SW8. The eighth changeover switch SW8 switches the connection destination of one end of the capacitor C12 to either the first node ND1 or the second node ND2. A switching state of the eighth changeover switch SW8 is controlled by a control means not illustrated. The connection destination of the other end of the capacitor C12 is fixed to the second node ND2.

In a case where one end of the capacitor C11 is connected to the first node ND1 by the seventh changeover switch SW7, the capacitor C11 functions as the band limiting capacitor. In contrast, in a case where one end of the capacitor C11 is connected to the second node ND2 by the seventh changeover switch SW7, the capacitor C11 does not function as the band limiting capacitor.

Similarly, in a case where one end of the capacitor C12 is connected to the first node ND1 by the eighth changeover switch SW8, the capacitor C12 functions as the band limiting capacitor. In contrast, in a case where one end of the capacitor C12 is connected to the second node ND2 by the eighth changeover switch SW8, the capacitor C12 does not function as the band limiting capacitor.

The control means causes only the capacitor C11 to function as the band limiting capacitor in a range in which the voltage level of the first output signal 1stOUT is higher than the inversion start voltage Vstart, and causes the capacitor C12 to function as the band limiting capacitor in addition to the capacitor C11 in a range in which the voltage level of the first output signal 1stOUT is lower than the inversion start voltage Vstart.

Therefore, the inclination of the change in voltage level of the first output signal 1stOUT is steep until the inversion of the second output signal 2ndOUT is started, and becomes gentle after the inversion of the second output signal 2ndOUT is started. As a result, the inversion delay time is shortened while maintaining the noise reduction effect at the time of inversion.

As described above, in the comparator circuit 1331 according to the thirteenth embodiment also, the inversion delay time can be shortened while maintaining the noise reduction effect at the time of inversion. Note that, the technique according to the thirteenth embodiment can be similarly applied to other embodiments. Furthermore, the control means may control in such a manner that the setting of the band limiting capacitor is switched according to a required noise amount and is set to a fixed value during the A/D conversion.

[Fourteenth Embodiment]

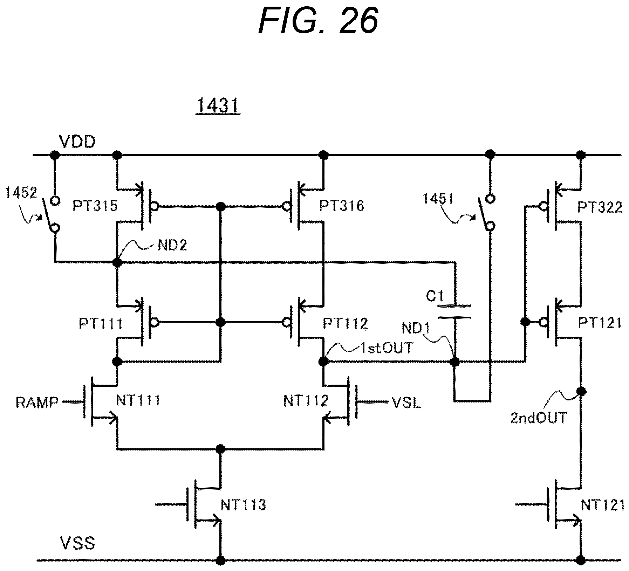

Fig. 26 is a diagram illustrating a substantial configuration of a comparator circuit 1431 of an imaging device according to a fourteenth embodiment of the present disclosure.

In the comparator circuit 1431 according to the fourteenth embodiment, the comparator circuit 331 according to the third embodiment described above is provided with an opening/closing switch for making an electric charge of the band limiting capacitor C1 to zero.

Specifically, a first opening/closing switch 1451 is provided between the first node ND1 to which one end of the band limiting capacitor C1 is connected and the power supply potential VDD, and a second opening/closing switch 1452 is provided between the second node ND2 to which the other end of the band limiting capacitor C1 is connected and the power supply potential VDD. Opening/closing states of the first opening/closing switch 1451 and the second opening/closing switch 1452 are controlled by a control means not illustrated. Note that, the second opening/closing switch 1452 may be omitted. The control means can make the electric charge stored in the band limiting capacitor C1 zero by closing the first opening/closing switch 1451 and (the second opening/closing switch 1452).

As described above, in the comparator circuit 1431 according to the fourteenth embodiment, the first opening/closing switch 1451 is provided between one end of the band limiting capacitor C1 and the power supply potential VDD, and the second opening/closing switch 1452 is provided between the other end of the band limiting capacitor C1 and the power supply potential VDD. With such feature, in the comparator circuit 1431 according to the fourteenth embodiment, the electric charge of the band limiting capacitor C1 can be made zero at any timing as necessary.

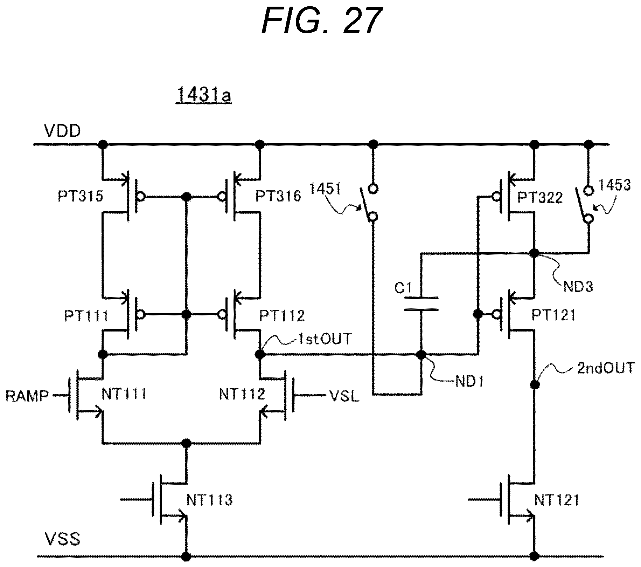

Note that, the technique according to the fourteenth embodiment can be similarly applied to other embodiments. For example, in Fig. 27, in the comparator circuit 731 according to the seventh embodiment described above, the first opening/closing switch 1451 is provided between the first node ND1 to which one end of the band limiting capacitor C1 is connected and the power supply potential VDD, and the second opening/closing switch 1453 is provided between the second node ND3 to which the other end of the band limiting capacitor C1 is connected and the power supply potential VDD.

[Fifteenth Embodiment]

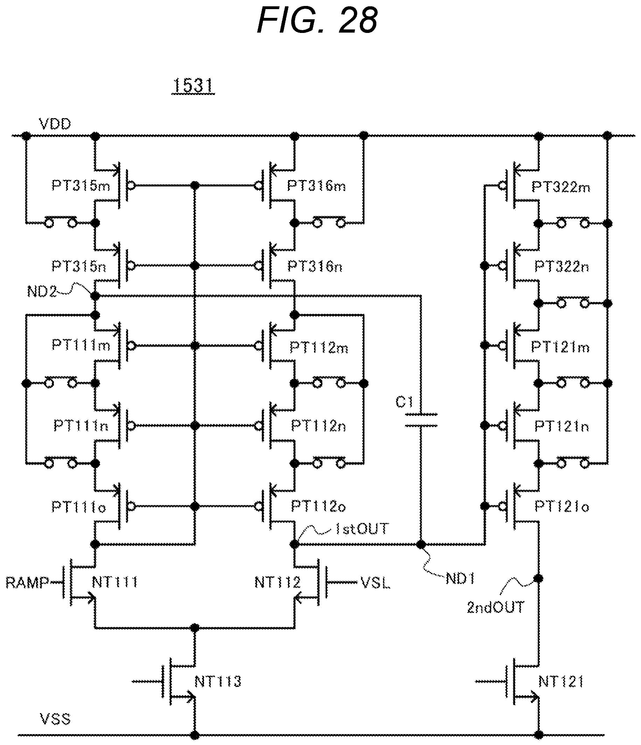

Fig. 28 is a diagram illustrating a substantial configuration of a comparator circuit 1531 of an imaging device according to a fifteenth embodiment of the present disclosure.

The comparator circuit 1531 according to the fifteenth embodiment is obtained by configuring a transistor of a substantially long channel length by connecting a plurality of transistors having short channel lengths in multiple stages and coupling the respective channels in the third embodiment described above.

As is well known, in a fine process, a transistor having a long channel length causes deterioration in circuit characteristic. In order to prevent this, a transistor having a substantially long channel length can be configured by coupling each channel by connecting transistors having a short channel length in multiple stages.

Specifically, the PMOS transistor PT111 is configured by coupling the respective channels by connecting three PMOS transistors PT111m to PT111o having short channel lengths in multiple stages. The PMOS transistor PT112 is configured by coupling the respective channels by connecting three PMOS transistors PT112m to PT112o having short channel lengths in multiple stages. The PMOS transistor PT315 is configured by coupling the respective channels by connecting two PMOS transistors PT315m and PT315n having short channel lengths in multiple stages. The PMOS transistor PT316 is configured by coupling the respective channels by connecting two PMOS transistors PT316m and PT316n having short channel lengths in multiple stages.

Furthermore, the PMOS transistor PT121 is configured by coupling the respective channels by connecting three PMOS transistors PT121m to PT121o having short channel lengths in multiple stages. The PMOS transistor PT322 is configured by coupling the respective channels by connecting two PMOS transistors PT322m and PT322n having short channel lengths in multiple stages.

As described above, in the comparator circuit 1531 according to the fifteenth embodiment, each PMOS transistor is configured by coupling the respective channels by connecting a plurality of transistors having short channel lengths in multiple stages. Therefore, the deterioration in circuit characteristic in the fine process can be prevented. Of course, the number of coupled transistors is not limited to two or three, and may be four or larger.

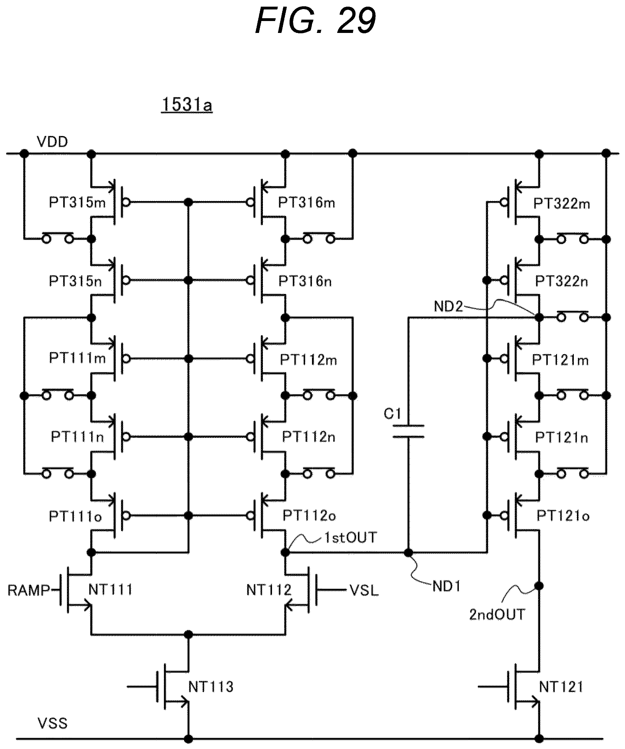

Note that, the technique according to the fifteenth embodiment can be similarly applied to other embodiments. For example, in Fig. 29, in the comparator circuit according to the seventh embodiment described above, each PMOS transistor is configured by coupling the respective channels by connecting a plurality of transistors having short channel lengths in multiple stages.

[Sixteenth Embodiment]

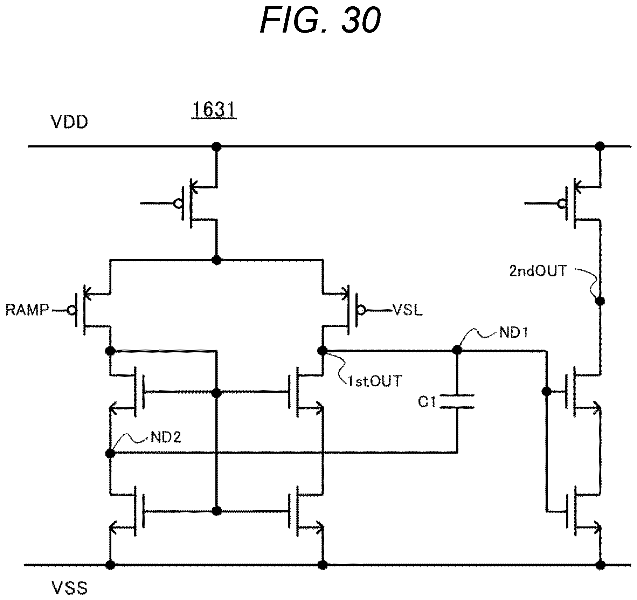

Fig. 30 is a diagram illustrating a substantial configuration of a comparator circuit 1631 of an imaging device according to a sixteenth embodiment of the present disclosure.

The comparator circuit 1631 according to the sixteenth embodiment is obtained by switching the relationship between the PMOS transistor and the NMOS transistor in the comparator circuit 31 according to the first embodiment described above. Even with such configuration, an effect similar to that of the comparator circuit 31 according to the first embodiment can be obtained.

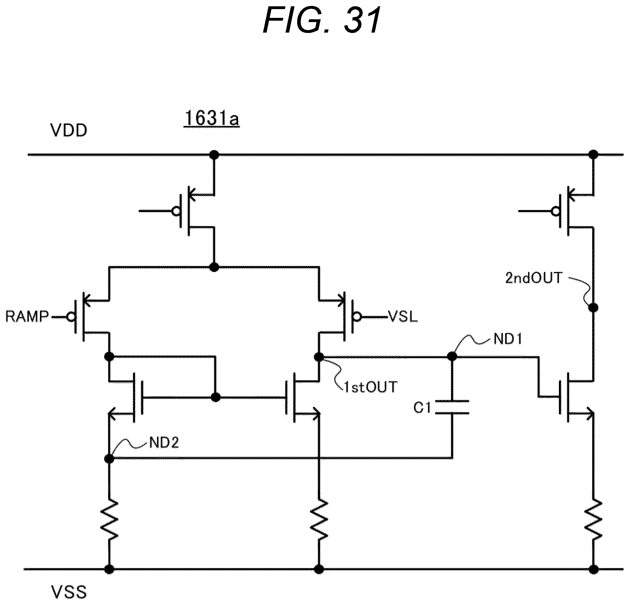

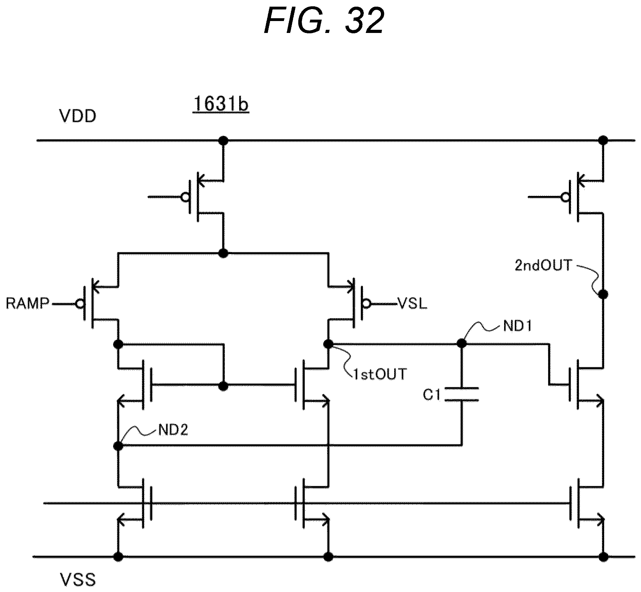

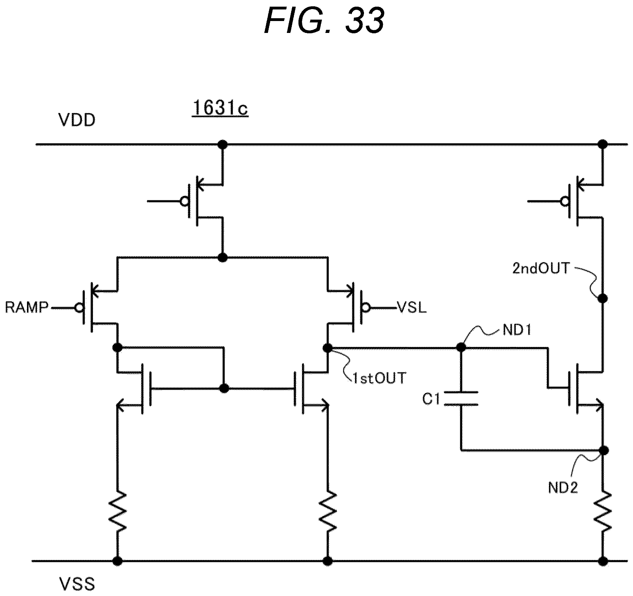

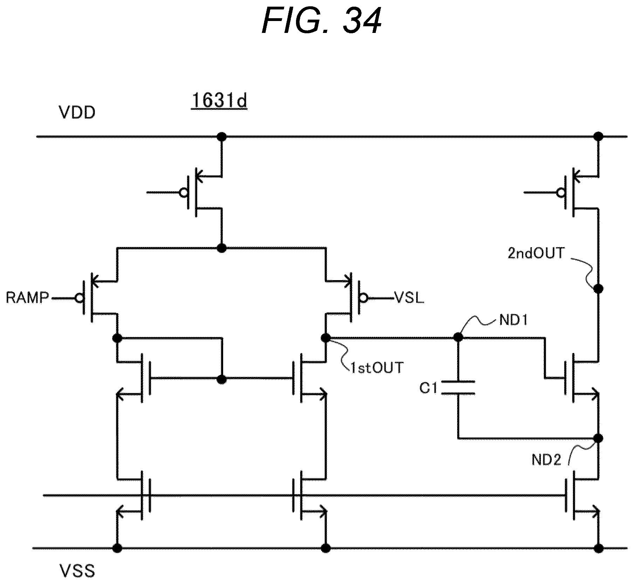

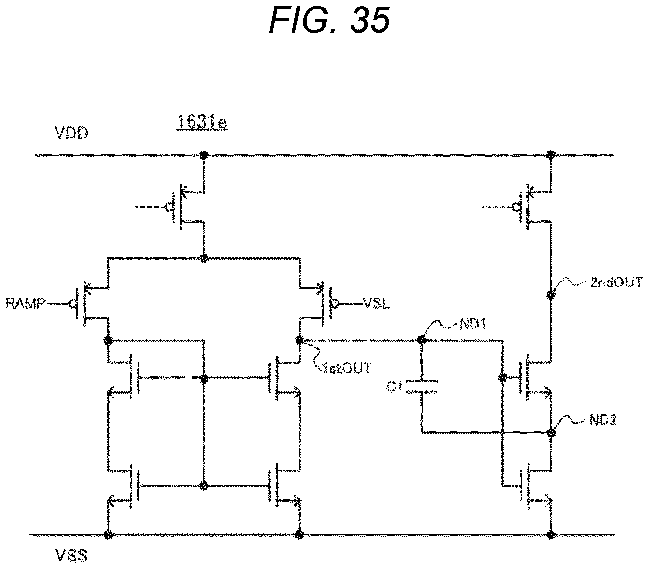

Note that, in other embodiments, the relationship between the PMOS transistor and the NMOS transistor can be exchanged. For example, in Figs. 31 to 35, the relationship between the PMOS transistor and the NMOS transistor is exchanged in the comparator circuit according to the second, third, and fifth to seventh embodiments described above.

[Seventeenth Embodiment]

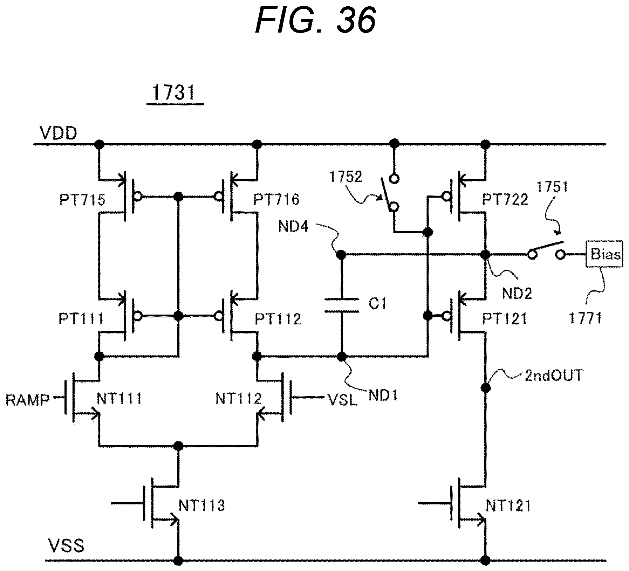

Fig. 36 is a diagram illustrating a substantial configuration of a comparator circuit 1731 of an imaging device according to a seventeenth embodiment of the present disclosure.

When an initial electric charge is stored in advance in the band limiting capacitor C1, the band can be limited while the stored initial electric charge is released. That is, by storing the initial electric charge in the band limiting capacitor C1, it is possible to further reduce the capacitance of the band control capacitor C1 while maintaining the noise reduction effect at the time of inversion.

In the comparator circuit 1731 according to the seventeenth embodiment, a bias circuit and an opening/closing switch for charging the band limiting capacitor C1 with the initial electric charge are provided in the comparator circuit 731 according to the seventh embodiment described above.

Specifically, the comparator circuit 1731 includes a first bias circuit 1771 that supplies the electric charge to the band limiting capacitor C1 from the second node ND2 side. Furthermore, a third opening/closing switch 1751 is provided between the first bias circuit 1771 and the second node ND2. Furthermore, a switch 1752 is provided between the first node ND1 to which one end of the band limiting capacitor C1 is connected and the power supply potential VDD. Opening/closing states of the third opening/closing switch 1751 and the switch 1752 are controlled by a control means not illustrated.

Before a comparison operation between the ramp signal RAMP and the pixel signal VSL, the control means closes the third opening/closing switch 1751 and the switch 1752, and supplies the initial electric charge generated by the first bias circuit 1771 to the band limiting capacitor C1. Furthermore, at the time of comparison operation, the control means opens the third opening/closing switch 1751 and the switch 1752 and limits the band using the band limiting capacitor C1.

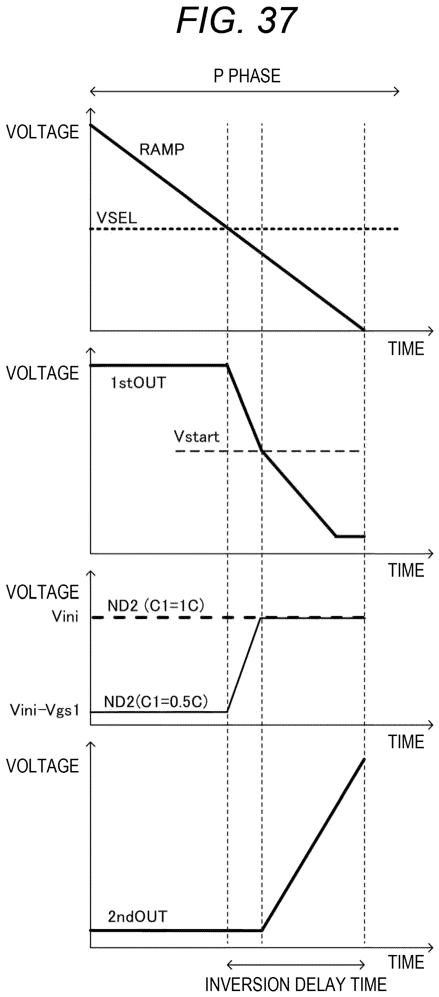

Fig. 37 is a time chart for comparing operations at the time of inversion of the comparator circuit 731 according to the seventh embodiment and the comparator circuit 1731 according to the seventeenth embodiment. In Fig. 37, a waveform indicating a voltage level of the second node ND2 according to the seventh embodiment is indicated by a dotted line, and a waveform indicating the voltage level of the second node ND2 according to the seventeenth embodiment is indicated by a solid line.

The capacitance of the band limiting capacitor C1 of the comparator circuit 731 is set to, for example, 1C. Furthermore, the voltage of the second node ND2 before the comparison operation is Vini (for example, Vini = VDD). The voltage level of the second node ND2 is fixed at Vini. Furthermore, the second output signal 2ndOUT is inverted to the high level (H) when the voltage level of the first node ND1 becomes equal to or lower than Vstart (for example, Vstart = Vini - Vgs1). In this case, the band limiting capacitor C1 according to the seventh embodiment can reduce noise corresponding to an electric charge amount of $1C \cdot Vgs1$. Note that, the inversion start voltage Vstart is not limited to the example described above, and may be appropriately set as a voltage exceeding a Vgs voltage at which both the PT722 and PT121 in Fig. 36 are turned on.

In contrast, the capacitance of the band limiting capacitor C1 of the comparator circuit 1731 is set to, for example, 1/2C. Furthermore, in the band limiting capacitor C1, the initial electric charge of $1/2C \cdot Vgs1$ is accumulated by the bias circuit 1771 before the comparison operation. Therefore, the voltage level of the second node ND2 becomes Vini - Vgs1 immediately before the comparison operation. In this case, the band limiting capacitor C1 according to the seventeenth embodiment can reduce noise corresponding to an electric charge amount of $1/2C \cdot 2Vgs1 (= 1C \cdot Vgs1)$.

That is, the band limiting capacitor C1 according to the seventeenth embodiment has the noise reduction effect equivalent to that of the band limiting capacitor C1 according to the seventh embodiment. Moreover, the band limiting capacitor C1 according to the seventeenth embodiment can make the capacitance 1/2 from the band limiting capacitor C1 according to the seventh embodiment.

Furthermore, by reducing the capacitance of the band limiting capacitor C1, the slew rate of 1stOUT can be further increased, and a power supply rejection ratio (PSRR) of the comparator circuit 1731 can be improved.

A voltage corresponding to a drain voltage of the PMOS transistor PT111 before the comparison operation is Vgs1, for example. The electric charge supplied by the bias circuit 1771 is adjusted on the basis of, for example, a voltage obtained by sampling and holding (S/H) and the like the drain voltage of the PMOS transistor PT111.

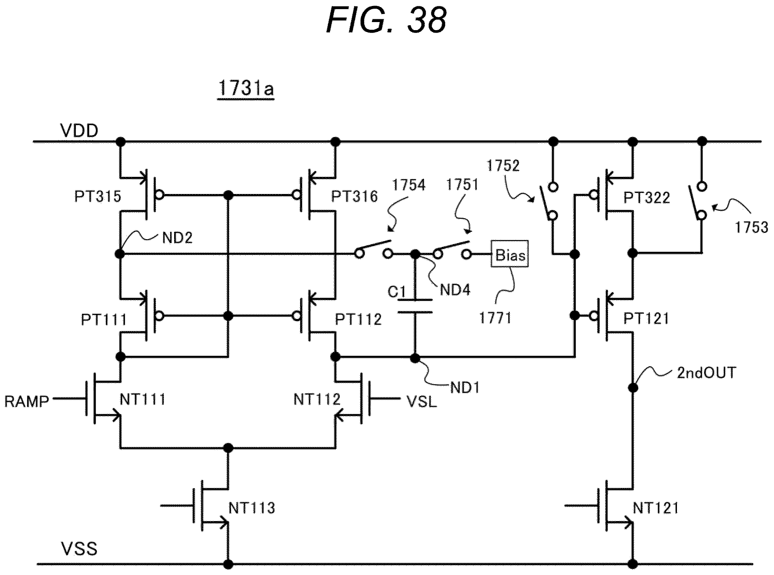

Note that, the technique according to the seventeenth embodiment can be similarly applied to other embodiments. For example, Fig. 38 illustrates an application example to the comparator circuit 331 according to the third embodiment described above. In Fig. 38, a third node ND4 is formed between one end of the band limiting capacitor C1 and the second node ND2. Furthermore, the third opening/closing switch 1751 is arranged between the third node ND4 and the first bias circuit 1771. Furthermore, the switch 1752 is provided between the first node ND1 to which one end of the band limiting capacitor C1 is connected and the power supply potential VDD, and a switch 1753 is provided between the source of the PMOS transistor PT121 and the power supply potential VDD and a switch 1754 is provided between the third node ND4 and the second node ND2.

Before the comparison operation, the control means not illustrated closes the third opening/closing switch 1751 and the switches 1752 and 1753, and opens the switch 1754. Furthermore, at the time of comparison operation, the control means opens the third opening/closing switch 1751 and the switches 1752 and 1753, and closes the switch 1754.

[Eighteenth Embodiment]

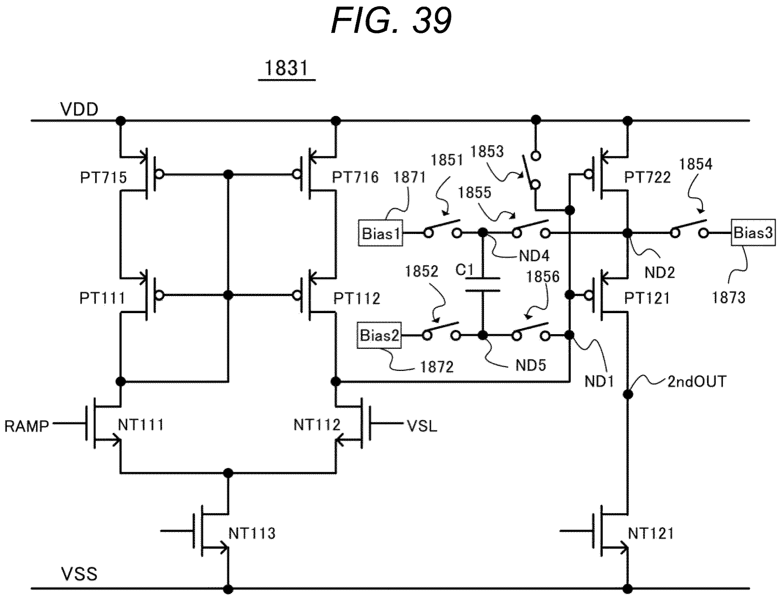

Fig. 39 is a diagram illustrating a substantial configuration of a comparator circuit 1831 of an imaging device according to an eighteenth embodiment of the present disclosure.

In the comparator circuit 1831 according to the eighteenth embodiment, a bias circuit and an opening/closing switch are provided on both ends of the band limiting capacitor C1 in the seventeenth embodiment described above.

Specifically, the third node ND4 is formed between one end of the band limiting capacitor C1 and the second node ND2, and a fourth node ND5 is formed between the other end of the band limiting capacitor C1 and the first node ND1. The comparator circuit 1831 includes a first bias circuit 1871 that supplies an electric charge to the band limiting capacitor C1 from the third node ND4 side, a second bias circuit 1872 that supplies an electric charge to the band limiting capacitor C1 from the fourth node ND5 side, and a third bias circuit 1873 that resets an initial electric charge of the second node

ND2.

The second bias circuit 1872 applies a voltage different from that of the first bias circuit 1871, and provides a potential difference between both ends of the band limiting capacitor C1. In the example of Fig. 39, the bias circuit 1872 applies a voltage higher than that of the first bias circuit 1871, for example. Note that, as in the sixteenth embodiment, in a case where the relationship between the PMOS transistor and the NMOS transistor is exchanged, the bias circuit 1872 may apply a voltage lower than that of the first bias circuit 1871.

A third opening/closing switch 1851 is connected between the third node ND4 and the first bias circuit 1871. A fourth opening/closing switch 1852 is connected between the fourth node ND5 and the second bias circuit 1872. In addition, a switch 1853 is provided between the first node ND1 and the power supply potential VDD, and a switch 1854 is provided between the second node ND2 and the third bias circuit 1873. A switch 1855 is provided between the second node ND2 and the third node ND4, and a switch 1856 is provided between the first node ND1 and the fourth node ND5. Opening/closing states of the third opening/closing switch 1851, the fourth opening/closing switch 1852, and the switches 1853 to 1856 are controlled by a control means not illustrated.

Before the comparison operation between the ramp signal RAMP and the pixel signal VSL, the control means closes the third opening/closing switch 1851, the fourth opening/closing switch 1852, and the switches 1853 and 1854, and opens the switches 1855 and 1856, thereby supplying the initial electric charge generated by the first bias circuit 1871 and the second bias circuit 1872 to the band limiting capacitor C1. Furthermore, at the time of comparison operation, the control means opens the third opening/closing switch 1851, the fourth opening/closing switch 1852, and the switches 1853 and 1854, and closes the switches 1855 and 1856, thereby limiting the band using the band limiting capacitor C1.

Therefore, immediately before the comparison operation, the voltage of the second node ND2 can be made lower than VDD. That is, the comparator circuit 1831 according to the eighteenth embodiment can further reduce the capacitance of the band control capacitor C1 while maintaining the noise reduction effect at the time of inversion.

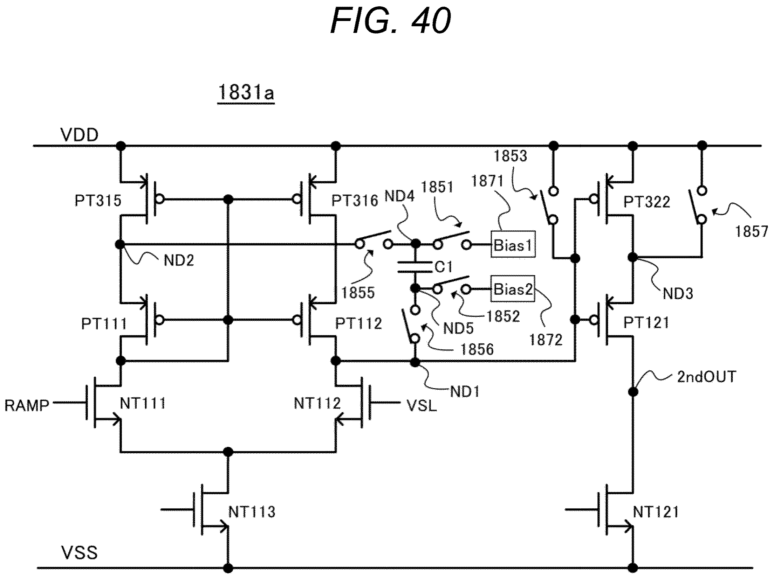

Note that, the technique according to the eighteenth embodiment can be similarly applied to other embodiments. For example, Fig. 40 illustrates an application example to the comparator circuit 331 according to the third embodiment described above. In Fig. 40, a switch 1857 is provided between the source of the PMOS transistor PT121 and the power supply potential VDD. The control means not illustrated closes the switch 1857 before the comparison operation, and opens the switch 1857 at the time of the comparison operation.

[Nineteenth Embodiment]

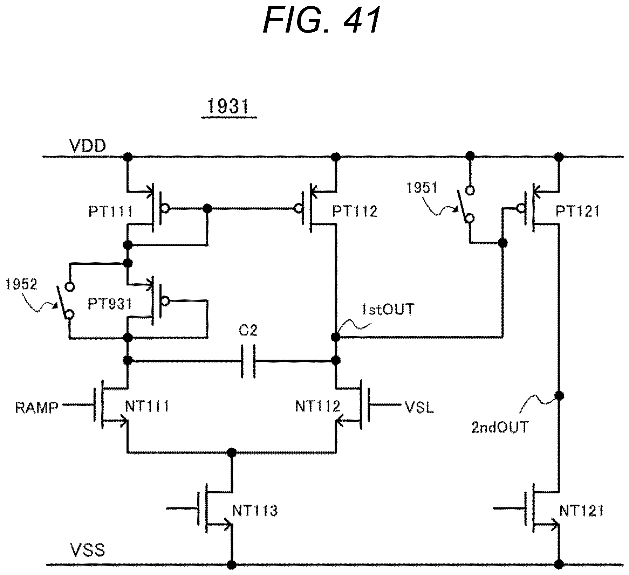

Fig. 41 is a diagram illustrating a substantial configuration of a comparator circuit 1931 of an imaging device according to a nineteenth embodiment of the present disclosure.

The comparator circuit 1931 according to nineteenth embodiment is obtained by applying the technology according to the seventeenth or eighteenth embodiment described above to the comparator circuit illustrated in Fig. 4A.

Specifically, the comparator circuit 1931 includes a PMOS transistor PT931, switches 1951 and 1952, and a band limiting capacitor C2. A source of the PMOS transistor PT931 is connected to the drain of the PMOS transistor PT111. A drain of the PMOS transistor PT931 is connected to the drain of the NMOS transistor NT111 and is short-circuited to a gate of the PMOS transistor PT931. The switch 1951 is arranged between the gate of the PMOS transistor PT121 and the power supply potential VDD. The switch 1952 is connected to the source and drain of the PMOS transistor PT931. In the band limiting capacitor C2, one end is connected to the drain of the NMOS transistor NT111 and the other end is connected to the drain of the NMOS transistor NT112. The capacitance of the band limiting capacitor C2 is set to, for example, 1/2C. The PMOS transistor PT931 is a "resistance element" in the nineteenth embodiment. Note that, a resistor may be arranged instead of the PMOS transistor PT931.

The control means not illustrated opens the switch 1952 and closes the switch 1951 before the comparison operation. Therefore, the band limiting capacitor C2 is supplied with the electric charge from the power supply potential VDD via the switch 1951. In the band limiting capacitor C2, for example, an initial electric charge having an electric charge amount of 1/2C·2Vgs1 is accumulated, similarly to the comparator circuit 1731 according to the seventeenth embodiment.

After the initial electric charge is accumulated in the band limiting capacitor C2, the control means opens the switch 1951. Furthermore, the control means closes the switch 1952 at the start of the comparison operation. Therefore, the voltage level of the first output signal 1stOUT at the start of the comparison operation increases by 2Vgs1. The comparator circuit 1931 has a noise reduction effect at the time of inversion according to the increase in the voltage level.

As a comparative example, a comparator circuit obtained by removing the switches 1951 and 1952 from the comparator circuit 1931 in which no initial electric charge is accumulated in the band limiting capacitor C2 can be considered. The comparator circuit 1931 according to the nineteenth embodiment can reduce the capacitance of the band limiting capacitor C2 to 1/2 of that of the comparative example described above.

[Twentieth Embodiment]

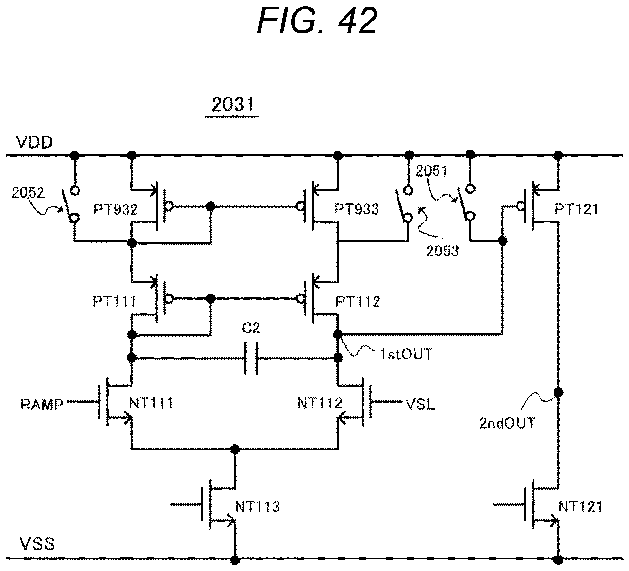

Fig. 42 is a diagram illustrating a substantial configuration of a comparator circuit 2031 of an imaging device according to a twentieth embodiment of the present disclosure.

The comparator circuit 2031 according to the twentieth embodiment is another configuration example obtained by applying the technology according to the seventeenth or eighteenth embodiment described above to the comparator circuit illustrated in Fig. 4A.

Specifically, a PMOS transistors PT932 is connected between the power supply potential VDD and the PMOS transistor PT111. A PMOS transistor PT933 is connected between the power supply potential VDD and the PMOS transistor PT112. The PMOS transistors PT932 and PT933 configure a current mirror circuit similarly to the PMOS transistors PT111 and PT112. A switch 2051 is arranged between the gate of the PMOS transistor PT121 and the power supply potential VDD. A switch 2052 is arranged between the power supply potential VDD and a drain of the PMOS transistor PT932. A switch 2053 is arranged between the power supply potential VDD and a drain of the PMOS transistor PT933. The band limiting capacitor C2 is arranged between the drain of the NMOS transistor NT111 and the drain of the NMOS transistor NT112. The PMOS transistors PT932 and PT933 are "resistance elements" in the twentieth embodiment. Note that, a resistor may be arranged instead of the PMOS transistors PT932 and PT933.

The control means not illustrated opens the switches 2052 and 2053 and closes the switch 2051 before the comparison operation. Therefore, the band limiting capacitor C2 is supplied with the electric charge from the power supply potential VDD via the switch 2051. After the initial electric charge is accumulated in the band limiting capacitor C2, the control means opens the switch 2051. Furthermore, the control means closes the switches 2052 and 2053 at the start of the comparison operation. Therefore, the voltage level of the first output signal 1stOUT at the start of the comparison operation increases.

Therefore, the voltage level of the first output signal 1stOUT can be increased at the start of the comparison operation. That is, the comparator circuit 2031 according to the twentieth embodiment can reduce the capacitance of the band control capacitor C2 while maintaining the noise reduction effect at the time of inversion.

[Modification]

In each of the embodiments described above, each transistor is not limited to the MOSFET, and may be, for example, FinFET, GAA-FET, CFET and the like. Furthermore, one or a plurality of third amplifier circuits may be provided at a preceding stage of the first amplifier circuit 110 or a subsequent stage of the second amplifier circuit 120. Furthermore, the first amplifier circuit 110 may be a single-input amplifier circuit and the like in place of the differential amplifier circuit.

Although some embodiments of the present disclosure have been described, these embodiments have been presented as examples and are not intended to limit the scope of the disclosure. These embodiments can be implemented in various other forms, and various omissions, substitutions, changes, and combinations can be made without departing from the gist of the disclosure. These embodiments and modifications thereof are included in the scope of the disclosure and the gist thereof, and also included in the disclosure recited in claims and the equivalents thereof.

Furthermore, the control means illustrated in the embodiment of the present disclosure may be implemented by software or by hardware. For example, each component may be a software module implemented by software such as a microprogram, and each component may be implemented by the processor executing the software module. Alternatively, each component may be implemented by a circuit block on a semiconductor chip (die), for example, an integrated circuit such as an application specific integrated circuit (ASIC) or a field programmable gate array (FPGA). Furthermore, the number of components and the number of pieces of hardware that implements the components are not necessarily the same. For example, one processor or circuit may implement a plurality of components. Conversely, one component may be implemented by a plurality of processors or circuits.

Furthermore, the effects of the present disclosure described in the present specification are merely an example, and there may be other effects.

Note that, the present disclosure can also have the following configurations.

[Item 1] (First to Sixteenth Embodiments)

An imaging device including: an A/D converter including a comparator circuit, in which

the comparator circuit
includes:

a first amplifier circuit;
a second amplifier circuit provided at a subsequent stage of the first amplifier circuit;
a band limiting capacitor provided between an output unit of the first amplifier circuit and an input unit of the second amplifier circuit; and
a resistance element with one end directly or indirectly connected to power supply potential or reference potential, and
one end of the band limiting capacitor is connected to a first node formed between the output unit of the first amplifier circuit and the input unit of the second amplifier circuit, and another end of the band limiting capacitor is connected to a second node formed in a middle or a terminal of the resistance element.

[Item 2] (First to Fourth and Fifth to Eighth Embodiments) (PMOS)

The imaging device according to the item 1, in which the first amplifier circuit includes a current mirror circuit provided on a side of the power supply potential and a differential pair provided on a downstream side of the current mirror circuit.

[Item 3] (First to Fourth Embodiment) (PMOS)

The imaging device according to the item 2, in which the second node is formed between the power supply potential and the current mirror circuit.

[Item 4] (First to Fourth Embodiments) (PMOS)

The imaging device according to the item 3, in which the current mirror circuit includes a first transistor diode-connected and a second transistor paired with the first transistor, and
the second node is formed between the power supply potential and the first transistor.

[Item 5] (Fifth to Eighth Embodiments) (PMOS)

The imaging device according to the item 2, in which the second amplifier circuit includes a third transistor provided on a side of the power supply potential, and

the second node is formed between the power supply potential and the third transistor.

[Item 6] (Sixteenth Embodiment) (NMOS)

The imaging device according to the item 1, in which the first amplifier circuit includes a current mirror circuit provided on a side of the reference potential, and a differential pair provided on an upstream side of the current mirror circuit.

[Item 7] (Sixteenth Embodiment) (NMOS)

The imaging device according to the item 6, in which the second node is formed between the reference potential and the current mirror circuit.

[Item 8] (Sixteenth Embodiment) (NMOS)

The imaging device according to the item 7, in which the current mirror circuit includes a first transistor diode-connected and a second transistor paired with the first transistor, and

the second node is formed between the reference potential and the first transistor.

[Item 9] (Sixteenth Embodiment) (NMOS)

The imaging device according to the item 6, in which the second amplifier circuit includes a third transistor provided on a side of the reference potential, and

the second node is formed between the reference potential and the third transistor.

[Item 10] (Second to Fourth and Sixth to Eighth Embodiment) (Sixteen Embodiment)

The imaging device according to any one of the items 1 to 9, in which the resistance element includes one or a plurality of MOS transistors.

[Item 11] (Fifteenth Embodiment)

The imaging device according to the item 10, in which at least one of the one or a plurality of transistors is configured by coupling respective channels by connecting a plurality of transistors in multiple stages.

[Item 12] (First and Fifth Embodiment) (Sixteenth Embodiment)

The imaging device according to any one of the items 1 to 11, in which the resistance element includes one or a plurality of resistors.

[Item 13] (Ninth Embodiment)

The imaging device according to any one of the items 1 to 12, in which the band limiting capacitor includes a MOSCAP.

[Item 14] (Tenth Embodiment)

The imaging device according to any one of the items 1 to 13, in which the band limiting capacitor includes a variable capacitor.

[Item 15] (Eleventh Embodiment)

The imaging device according to any one of the items 1 to 14, in which the band limiting capacitor includes a first capacitor and a second capacitor,

the imaging device further including:

a first changeover switch that switches a connection destination of one end of the first capacitor to either the first node or the power supply potential;
a second changeover switch that switches a connection destination of another end of the first capacitor to either the second node or the power supply potential;
a third changeover switch that switches a connection destination of one end of the second capacitor to either the first node or the power supply potential; and
a fourth changeover switch that switches a connection destination of another end of the second capacitor to either the second node or the power supply potential.

[Item 16] (Twelfth Embodiment)

The imaging device according to any one of the items 1 to 14, in which the band limiting capacitor includes a first capacitor and a second capacitor, and

a connection destination of another end of each of the first capacitor and the second capacitor is fixed to the second node,
the imaging device further including:

a fifth changeover switch that changes a connection destination of one end of the first capacitor to either the first node or the power supply potential, and
a sixth changeover switch that changes a connection destination of one end of the second capacitor to either the first node or the power supply potential.

[Item 17] (Thirteenth Embodiment)

The imaging device according to any one of the items 1 to 14, in which the band limiting capacitor includes a first capacitor and a second capacitor, and

a connection destination of another end of each of the first capacitor and the second capacitor is fixed to the second node,
the imaging device further including:

a seventh changeover switch that changes a connection destination of one end of the first capacitor to either the first node or the second node, and
an eighth changeover switch that changes a connection destination of one end of the second capacitor to either the first node or the second node.

[Item 18] (Fourteenth Embodiment)

The imaging device according to any one of the items 1 to 17, further including: a first opening/closing switch provided between one end of the band limiting capacitor and the power supply potential or the reference potential.

[Item 19] (Fourteenth Embodiment)

The imaging device according to the item 18, further including: a second opening/closing switch provided between another end of the band limiting capacitor and the power supply potential or the reference potential.
[Item 20] (Seventeenth Embodiment) The imaging device according to any one of the items 1 to 19, further including: a first bias circuit that applies a voltage to one end connected to the second node of the band limiting capacitor; and
a third opening/closing switch arranged between the one end of the band limiting capacitor and the first bias circuit.

[Item 21] (Eighteenth Embodiment)

The imaging device according to the item 20, further including: a second bias circuit that applies a voltage different from the voltage of the first bias circuit to another end of the band limiting capacitor; and
a fourth opening/closing switch arranged between the another end of the band limiting capacitor and the second bias circuit.

[Item 22] (Third Amplifier Circuit)

The imaging device according to any one of the items 1 to 21, further including: one or a plurality of third amplifier circuits provided at a preceding stage of the first amplifier circuit or a subsequent stage of the second amplifier circuit.

REFERENCE SIGNS LIST

| | |
|---|---|
| 1 | Imaging device |
| 11 | Pixel unit |
| 12 | Vertical scanning circuit |
| 13 | Horizontal transfer scanning circuit |
| 14 | Timing control circuit |
| 15 | D/A converter |
| 16 | A/D converter |
| 17 | Amplifier circuit |
| 18 | Signal processing circuit |
| 31 | Comparator circuit |
| 32 | Counter circuit |
| 33 | Latch |
| 110 | First amplifier circuit |
| 120 | Second amplifier circuit |
| 231 | Comparator circuit |
| 331 | Comparator circuit |
| 431 | Comparator circuit |
| 531 | Comparator circuit |
| 631 | Comparator circuit |
| 731 | Comparator circuit |
| 831 | Comparator circuit |
| 931 | Comparator circuit |
| 931a | Comparator circuit |
| 940 | MOSCAP |
| 1031 | Comparator circuit |
| 1031a | Comparator circuit |
| 1031b | Comparator circuit |
| 1041 | Variable capacitor |
| 1042 | Variable capacitor |
| 1043 | Variable capacitor |
| 1131 | Comparator circuit |
| 1231 | Comparator circuit |
| 1331 | Comparator circuit |
| 1431 | Comparator circuit |
| 1431a | Comparator circuit |
| 1451 | First opening/closing switch |
| 1452 | Second opening/closing switch |
| 1453 | Second opening/closing switch |
| 1531 | Comparator circuit |
| 1531a | Comparator circuit |
| 1631 | Comparator circuit |
| 1631a | Comparator circuit |
| 1631b | Comparator circuit |
| 1631c | Comparator circuit |
| 1631d | Comparator circuit |
| 1731 | Comparator circuit |
| 1731a | Comparator circuit |

| | |
|---|---|
| 1751 | Third opening/closing switch |
| 1752 | Switch |
| 1753 | Switch |
| 1754 | Switch |
| 1771 | First bias circuit |
| 1831 | Comparator circuit |
| 1831a | Comparator circuit |
| 1851 | Third opening/closing switch |
| 1852 | Fourth opening/closing switch |
| 1853 | Switch |
| 1854 | Switch |
| 1855 | Switch |
| 1856 | Switch |
| 1857 | Switch |
| 1871 | First bias circuit |
| 1872 | Second bias circuit |
| 1873 | Third bias circuit |
| 1931 | Comparator circuit |
| 1951 | Switch |
| 1952 | Switch |
| 2031 | Comparator circuit |
| 2051 | Switch |
| 2052 | Switch |
| 2053 | Switch |
| 1stOUT | First output signal |
| 2ndOUT | Second output signal |
| BIAS | Bias signal |
| C | Band limiting capacitor of conventional technology |
| C1 | Band limiting capacitor |
| C11 | Band limiting capacitor |
| C12 | Band limiting capacitor |
| C111 | Capacitor |
| C112 | Capacitor |
| C121 | Capacitor |
| C2 | Band limiting capacitor |
| LTRF | Horizontal transfer line |
| ND1 | First node |
| ND111 | Output unit of first amplifier circuit |
| ND121 | Output unit of second amplifier circuit |
| ND2 | Second node |
| ND3 | Second node |
| ND4 | Third node |
| ND5 | Fourth node |
| NSEL | Second AZ signal |
| NT111 | NMOS transistor |
| NT112 | NMOS transistor |
| NT113 | NMOS transistor |
| NT121 | NMOS transistor |
| NT122 | NMOS transistor |
| PT111 | PMOS transistor |
| PT111m | PMOS transistor |
| PT111n | PMOS transistor |
| PT112 | PMOS transistor |
| PT112m | PMOS transistor |
| PT112n | PMOS transistor |
| PT113 | PMOS transistor |
| PT114 | PMOS transistor |
| PT121 | PMOS transistor |

PT121m PMOS    transistor
PT121n         PMOS transistor
PT215          PMOS transistor (resistance element)
PT216          PMOS transistor
PT222          PMOS transistor
PT315          PMOS transistor (resistance element)
PT315m         PMOS transistor (resistance element)
PT315n         PMOS transistor (resistance element)
PT316          PMOS transistor
PT316m         PMOS transistor
PT316n         PMOS transistor
PT322          PMOS transistor
PT322m         PMOS transistor
PT322n         PMOS transistor
PT415a         PMOS transistor (resistance element)
PT415b         PMOS transistor (resistance element)
PT415c         PMOS transistor (resistance element)
PT416a         PMOS transistor
PT416b         PMOS transistor
PT416c         PMOS transistor
PT422a         PMOS transistor
PT422b         PMOS transistor
PT422c         PMOS transistor
PT615          PMOS transistor
PT616          PMOS transistor
PT622          PMOS transistor (resistance element)
PT715          PMOS transistor
PT716          PMOS transistor
PT722          PMOS transistor (resistance element)
PT815a         PMOS transistor
PT815b         PMOS transistor
PT815c         PMOS transistor
PT816a         PMOS transistor
PT816b         PMOS transistor
PT816c         PMOS transistor
PT822a         PMOS transistor (resistance element)
PT822b         PMOS transistor (resistance element)
PT822c         PMOS transistor (resistance element)
PT931          PMOS transistor (resistance element)
PT932          PMOS transistor (resistance element)
PT933          PMOS transistor (resistance element)
PSEL           AZ signal
R111           Resistor (resistance element)
R112           Resistor
R121           Resistor (resistance element)
RAMP           Ramp signal
SW1            First changeover switch
SW2            Second changeover switch
SW3            Third changeover switch
SW4            Fourth changeover switch
SW5            Fifth changeover switch
SW6            Sixth changeover switch
SW7            Seventh changeover switch
SW8            Eighth changeover switch
TBIAS          Input terminal of bias signal
TNSEL          Input terminal of second AZ signal
TOUT           Output terminal of comparator circuit
TPSEL          Input terminal of first AZ signal

| TRAMP | Input terminal of Ramp signal |
| TVSL | Input terminal of pixel signal |
| VDD | Power supply potential |
| VSS | Reference potential |
| VSL | Pixel signal |
| Vslop | Reference voltage Vstart Inversion start voltage |

**Claims**

1. An imaging device comprising: an A/D converter including a comparator circuit, wherein

   the comparator circuit
   includes:

   a first amplifier circuit;
   a second amplifier circuit provided at a subsequent stage of the first amplifier circuit;
   a band limiting capacitor provided between an output unit of the first amplifier circuit and an input unit of the second amplifier circuit; and
   a resistance element with one end directly or indirectly connected to power supply potential or reference potential, and
   one end of the band limiting capacitor is connected to a first node formed between the output unit of the first amplifier circuit and the input unit of the second amplifier circuit, and another end of the band limiting capacitor is connected to a second node formed in a middle or a terminal of the resistance element.

2. The imaging device according to claim 1, wherein the first amplifier circuit includes a current mirror circuit provided on a side of the power supply potential and a differential pair provided on a downstream side of the current mirror circuit.

3. The imaging device according to claim 2, wherein the second node is formed between the power supply potential and the current mirror circuit.

4. The imaging device according to claim 3, wherein the current mirror circuit includes a first transistor diode-connected and a second transistor paired with the first transistor, and
   the second node is formed between the power supply potential and the first transistor.

5. The imaging device according to claim 2, wherein the second amplifier circuit includes a third transistor provided on a side of the power supply potential, and
   the second node is formed between the power supply potential and the third transistor.

6. The imaging device according to claim 1, wherein the first amplifier circuit includes a current mirror circuit provided on a side of the reference potential, and a differential pair provided on an upstream side of the current mirror circuit.

7. The imaging device according to claim 6, wherein the second node is formed between the reference potential and the current mirror circuit.

8. The imaging device according to claim 7, wherein the current mirror circuit includes a first transistor diode-connected and a second transistor paired with the first transistor, and
   the second node is formed between the reference potential and the first transistor.

9. The imaging device according to claim 6, wherein the second amplifier circuit includes a third transistor provided on a side of the reference potential, and
   the second node is formed between the reference potential and the third transistor.

10. The imaging device according to claim 1, wherein the resistance element includes one or a plurality of MOS transistors.

11. The imaging device according to claim 10, wherein at least one of the one or a plurality of transistors is configured by coupling respective channels by connecting a plurality of transistors in multiple stages.

12. The imaging device according to claim 1, wherein the resistance element includes one or a plurality of resistors.

13. The imaging device according to claim 1, wherein the band limiting capacitor includes a MOSCAP.

14. The imaging device according to claim 1, wherein the band limiting capacitor includes a variable capacitor.

15. The imaging device according to claim 1, wherein the band limiting capacitor includes a first capacitor and a second capacitor,
the imaging device further comprising:

a first changeover switch that switches a connection destination of one end of the first capacitor to either the first node or the power supply potential;
a second changeover switch that switches a connection destination of another end of the first capacitor to either the second node or the power supply potential;
a third changeover switch that switches a connection destination of one end of the second capacitor to either the first node or the power supply potential; and
a fourth changeover switch that switches a connection destination of another end of the second capacitor to either the second node or the power supply potential.

16. The imaging device according to claim 1, wherein the band limiting capacitor includes a first capacitor and a second capacitor, and

a connection destination of another end of each of the first capacitor and the second capacitor is fixed to the second node,
the imaging device further comprising:

a fifth changeover switch that changes a connection destination of one end of the first capacitor to either the first node or the power supply potential, and
a sixth changeover switch that changes a connection destination of one end of the second capacitor to either the first node or the power supply potential.

17. The imaging device according to claim 1, wherein the band limiting capacitor includes a first capacitor and a second capacitor, and

a connection destination of another end of each of the first capacitor and the second capacitor is fixed to the second node,
the imaging device further comprising:

a seventh changeover switch that changes a connection destination of one end of the first capacitor to either the first node or the second node, and
an eighth changeover switch that changes a connection destination of one end of the second capacitor to either the first node or the second node.

18. The imaging device according to claim 1, further comprising: a first opening/closing switch provided between one end of the band limiting capacitor and the power supply potential or the reference potential.

19. The imaging device according to claim 18, further comprising: a second opening/closing switch provided between another end of the band limiting capacitor and the power supply potential or the reference potential.

20. The imaging device according to claim 1, further comprising: a first bias circuit that applies a voltage to one end connected to the second node of the band limiting capacitor; and
a third opening/closing switch arranged between the one end of the band limiting capacitor and the first bias circuit.

21. The imaging device according to claim 20, further comprising: a second bias circuit that applies a voltage different from the voltage of the first bias circuit to another end of the band limiting capacitor; and
a fourth opening/closing switch arranged between the another end of the band limiting capacitor and the second bias circuit.

22. The imaging device according to claim 1, further comprising: one or a plurality of third amplifier circuits provided at a preceding stage of the first amplifier circuit or a subsequent stage of the second amplifier circuit.

# FIG. 1

FIG. 2

EP 4 694 175 A1

# FIG. 3

P PHASE

VOLTAGE
RAMP
VSEL
TIME

VOLTAGE
1stOUT
Vstart
TIME

VOLTAGE
2ndOUT
TIME
INVERSION DELAY TIME

## FIG. 4A

RAMP = VSL

## FIG. 4B

RAMP < VSL

# FIG. 5A

RAMP = VSL

31

# FIG. 5B

RAMP < VSL

31

# FIG. 6

# FIG. 7

# FIG. 8

431

VDD

PT415a  PT416a

PT415b  PT416b

PT415c  PT416c

ND2

PT111  PT112  C1  PT121

1stOUT

NT111  NT112  ND1

RAMP  VSL

2ndOUT

NT113

VSS

NT121

PT422a

PT422b

PT422c

## FIG. 9

| IMPEDANCE OF RESISTANCE COMPONENT | NUMBER OF TRANSISTORS | | CURRENT Ic FLOWING THROUGH C1 | CURRENT FLOWING THROUGH C1 (WITH REFERENCE TO CONVENTIONAL TECHNOLOGY) | CAPACITANCE OF SAME SLEW RATE (WITH REFERENCE TO CONVENTIONAL TECHNOLOGY) |
|---|---|---|---|---|---|
| | VDD SIDE N1 | DIFFERENTIAL PAIR SIDE N2 | | | |
| 0 | 0 | 1 | $\triangle$ Iout | ONE TIME (REFERENCE) | ONE TIME (REFERENCE) |
| (1/gm)/3 | 1 | 3 | $\triangle$ Iout*(4/5) | 4/5 TIMES | 4/5 TIMES |
| (1/gm)/2 | 1 | 2 | $\triangle$ Iout*(3/4) | 3/4 TIMES | 3/4 TIMES |
| (1/gm) | 1 | 1 | $\triangle$ Iout*(2/3) | 2/3 TIMES | 2/3 TIMES |
| (1/gm)*2 | 2 | 1 | $\triangle$ Iout*(3/5) | 3/5 TIMES | 3/5 TIMES |
| (1/gm)*3 | 3 | 1 | $\triangle$ Iout*(4/7) | 4/7 TIMES | 4/7 TIMES |
| .... | ... | ... | ... | ... | ... |
| (1/gm)*9 | 9 | 1 | $\triangle$ Iout*(10/19) | 10/19 TIMES | 10/19 TIMES |

EFFECT OF REDUCING CAPACITANCE IS LARGE

# FIG. 10

# FIG. 11

(1)　(2)　(3)

VOLTAGE

RAMP

VSEL

TIME

VOLTAGE

VDD

1stOUT

Vstart

TIME

VOLTAGE

2ndOUT

TIME

INVERSION DELAY TIME

# FIG. 12A

531

(1) RAMP = VSL

# FIG. 12B

531

(2) RAMP < VSL & 1stOUT > Vstart

# FIG. 12C

EP 4 694 175 A1

531

(3) RAMP < VSL & 1stOUT < Vstart

# FIG. 13

# FIG. 14

<u>731</u>

# FIG. 15

# FIG. 16

| NUMBER OF TRANSISTORS | | Gm (OUTPUT SIDE Tr) | $\Delta I2$ |
|---|---|---|---|
| VDD SIDE N1 | OUTPUT SIDE N2 | | |
| 1 | 3 | $gm/\sqrt{3}$ | $gm/\sqrt{3} \cdot \Delta I1 \cdot \Delta t/C$ |
| 1 | 2 | $gm/\sqrt{2}$ | $gm/\sqrt{2} \cdot \Delta I1 \cdot \Delta t/C$ |
| 1 | 1 | $gm$ | $gm \cdot \Delta I1 \cdot \Delta t/C$ |
| 2 | 1 | $gm$ | $gm \cdot \Delta I1 \cdot \Delta t/C$ |
| 3 | 1 | $gm$ | $gm \cdot \Delta I1 \cdot \Delta t/C$ |

# FIG. 17

# FIG. 18

P PHASE

VOLTAGE

RAMP

VSEL

TIME

VOLTAGE

1stOUT

Vstart

TIME

CAPACITANCE

MOSCAP

TIME

VOLTAGE

2ndOUT

TIME

INVERSION DELAY TIME

# FIG. 19

# FIG. 20

# FIG. 21

# FIG. 22

1031b

# FIG. 23

# FIG. 24

# FIG. 25

<u>1331</u>

# FIG. 26

# FIG. 27

# FIG. 28

# FIG. 29

# FIG. 30

# FIG. 31

# FIG. 32

# FIG. 33

# FIG. 34

# FIG. 35

# FIG. 36

1731

# FIG. 37

P PHASE

VOLTAGE

RAMP

VSEL

TIME

VOLTAGE

1stOUT

Vstart

TIME

VOLTAGE
Vini

ND2 (C1=1C)

Vini-Vgs1

ND2(C1=0.5C)

TIME

VOLTAGE

2ndOUT

TIME

INVERSION DELAY TIME

# FIG. 38

*FIG. 39*

1831

VDD

PT715  PT716  1871  1851  1853  PT722  1854

Bias1  1855  ND4  1856  Bias3  1873

C1

PT111  PT112  1852  Bias2  1872  ND2  PT121  ND1  2ndOUT

ND5

NT111  NT112  VSL  NT113  NT121

RAMP

VSS

FIG. 40

FIG. 41

# FIG. 42

## INTERNATIONAL SEARCH REPORT

| International application No. |
| --- |
| **PCT/JP2024/011718** |

| | |
| --- | --- |
| **A.** | **CLASSIFICATION OF SUBJECT MATTER** |
| | *H04N 25/78*(2023.01)i; *H03K 5/08*(2006.01)i<br>FI:  H04N25/78; H03K5/08 E |

According to International Patent Classification (IPC) or to both national classification and IPC

| | |
| --- | --- |
| **B.** | **FIELDS SEARCHED** |

Minimum documentation searched (classification system followed by classification symbols)

H04N25/78; H03K5/08

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| | |
| --- | --- |
| **C.** | **DOCUMENTS CONSIDERED TO BE RELEVANT** |

| Category* | Citation of document, with indication, where appropriate, of the relevant passages | Relevant to claim No. |
| --- | --- | --- |
| A | JP 2020-113892 A (BRILLNICS INC.) 27 July 2020 (2020-07-27)<br>paragraph [0138], fig. 9 | 1-22 |
| A | JP 2014-017838 A (SONY CORPORATION) 30 January 2014 (2014-01-30)<br>paragraph [0062], fig. 10 | 1-22 |
| A | JP 2007-281540 A (SONY CORPORATION) 25 October 2007 (2007-10-25)<br>paragraph [0061], fig. 3 | 1-22 |
| A | WO 2019/150917 A1 (SONY SEMICONDUCTOR SOLUTIONS CORPORATION) 08 August 2019 (2019-08-08)<br>paragraph [0136], fig. 20 | 1-22 |
| A | JP 2021-048588 A (PANASONIC INTELLECTUAL PROPERTY MANAGEMENT CO., LTD.) 25 March 2021 (2021-03-25)<br>paragraph [0116], fig. 16 | 1-22 |

☑ Further documents are listed in the continuation of Box C.  ☑ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **16 May 2024** | **28 May 2024** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

## INTERNATIONAL SEARCH REPORT

International application No.

**PCT/JP2024/011718**

### C. DOCUMENTS CONSIDERED TO BE RELEVANT

| Category* | Citation of document, with indication, where appropriate, of the relevant passages | Relevant to claim No. |
|---|---|---|
| A | US 2019/0123692 A1 (ANALOG DEVICES GLOBAL ULIMITED COMPANY) 25 April 2019 (2019-04-25)<br>paragraphs [0043]-[0045], fig. 10 | 1-22 |

Form PCT/ISA/210 (second sheet) (July 2022)

### INTERNATIONAL SEARCH REPORT
Information on patent family members

| | International application No. |
|---|---|
| | **PCT/JP2024/011718** |

| Patent document cited in search report | | | Publication date (day/month/year) | Patent family member(s) | | | Publication date (day/month/year) |
|---|---|---|---|---|---|---|---|
| JP | 2020-113892 | A | 27 July 2020 | US 2020/0228740 A1 paragraph [0160], fig. 9 EP 3681147 A1 CN 111435976 A TW 202042544 A | | | |
| JP | 2014-017838 | A | 30 January 2014 | (Family: none) | | | |
| JP | 2007-281540 | A | 25 October 2007 | US 2008/0111905 A1 paragraph [0070], fig. 3 KR 10-2007-0099479 A CN 101056363 A TW 200742426 A | | | |
| WO | 2019/150917 | A1 | 08 August 2019 | US 2022/0094871 A1 paragraph [0240], fig. 20 EP 3748958 A1 CN 111615824 A | | | |
| JP | 2021-048588 | A | 25 March 2021 | (Family: none) | | | |
| US | 2019/0123692 | A1 | 25 April 2019 | WO 2019/081354 A1 | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2020188477 A